# EUROPÄISCHE PATENTANMELDUNG

(11) **EP 3 043 370 A1**
(43) Veröffentlichungstag der Anmeldung: **13.07.2016**
(21) Anmeldenummer: 15150613.6
(22) Anmeldetag: 09.01.2015
(51) Int. Cl.: H01J 27/02, H01J 37/08

(54) **Vorrichtung zur Extraktion von elektrischen Ladungsträgern aus einem Ladungsträgererzeugungsraum sowie ein Verfahren zum Betreiben einer solchen Vorrichtung**

(71) Anmelder: Meyer Burger (Germany) AG, 09337 Hohenstein-Ernstthal (DE)
(72) Erfinder: Mai, Joachim, 04603 Nobitz (DE); Luca, Alfonz, Dr., 09126 Chemnitz (DE); Sarstedt, Margit, Dr., 60435 Frankfurt am Main (DE)
(74) Vertreter: Kailuweit & Uhlemann Patentanwälte Partnerschaft mbB

(57) **Zusammenfassung**

Die Erfindung betrifft eine Vorrichtung zur Extraktion von elektrischen Ladungsträgern aus einem Ladungsträgererzeugungsraum mit mindestens einer Elektrodenanordnung 1a zur Extraktion von Ladungsträgern, wobei die mindestens eine Elektrodenanordnung mindestens eine erste Gitterelektrode und eine zweite Gitterelektrode mit korrespondierenden Öffnungen aufweist. Die erste und die zweite Gitterelektrode enthalten jeweils mindestens einen ersten elektrisch leitfähigen Gitterelektrodenbereich 110,210, wobei der mindestens eine erste Gitterelektrodenbereich 110a,b der ersten Gitterelektrode in einer ersten Lage 100 und der mindestens eine erste Gitterelektrodenbereich 210a,b der zweiten Gitterelektrode in einer zweiten Lage 200 ausgebildet sind. Die erste Lage und die zweite Lage sind innerhalb der Elektrodenanordnung in Teilchenaustrittsrichtung nacheinander angeordnet und voneinander durch einen ersten Abstand 300 entlang der Teilchenaustrittsrichtung beabstandet, wobei der mindestens eine erste Gitterelektrodenbereich 110a, b der ersten Gitterelektrode in der ersten Lage einen ersten elektrisch leitfähigen Lagenanteil 101 bildet. Darüber hinaus ist in der ersten Lage ein zweiter elektrisch leitfähiger Lagenanteil 102 ausgebildet, der elektrisch vom ersten Lagenanteil 101 isoliert ist. Der zweite Lagenanteil 102 wird durch mindestens einen zweiten elektrisch leitfähigen Gitterelektrodenbereich der ersten Gitterelektrode oder der zweiten Gitterelektrode gebildet und der zweite Lagenanteil 102 ist elektrisch leitend 301 mit dem mindestens einen ersten Gitterelektrodenbereich 210a,b der zweiten Gitterelektrode verbunden. Die erfindungsgemäße Vorrichtung zur Extraktion von Ladungsträgern stellt somit eine elektrisch schaltbare Extraktionsgitterelektrodenanordnung dar, mit deren Hilfe die Strahlcharakteristik eines Teilchenstrahls aus extrahierten Ladungsträgern verändert werden kann.

## Beschreibung

Die Erfindung betrifft eine Vorrichtung zur Extraktion von elektrischen Ladungsträgern aus einem Ladungsträgererzeugungsraum, die eine Änderung der Form des mit Hilfe der Vorrichtung extrahierten Teilchengesamtstrahls ermöglicht, sowie ein Verfahren zum Betreiben einer solchen Vorrichtung. Darüber hinaus betrifft die Erfindung ein Verfahren zum Bearbeiten der Oberfläche eines Substrates unter Nutzung eines oder mehrerer Teilchengesamtstrahlen, die mit mindestens einer derartigen Vorrichtung erzeugt wurden.

Gerichtete Teilchenstrahlen aus elektrischen Ladungsträgern, bspw. Ionenstrahlen oder Elektronenstrahlen, werden in einer Teilchenstrahlquelle durch die Extraktion von elektrischen Ladungsträgern, also Ionen oder Elektronen, aus einem Ladungsträgererzeugungsraum, bspw. einem Plasma, erzeugt, wobei die Teilchen sich nach Verlassen der Teilchenstrahlquelle gerichtet und strahlförmig im Raum in eine Teilchenaustrittsrichtung bewegen. Dazu werden, insbesondere zur Erzeugung von Breitstrahlen mit einer Strahlbreite von bis zu 1 m, eine oder mehrere Vorrichtung zur Extraktion von elektrischen Ladungsträgern eingesetzt, die jeweils aus einer oder mehreren Gitterelektroden bestehen und die Teilchen aus dem Ladungsträgererzeugungsraum extrahieren und ggf. beschleunigen sowie die dabei entstehenden einzelnen Teilchenteilstrahlen zueinander ausrichten. Unter einer Gitterelektrode wird dabei ein mechanischer (physischer oder materieller) Verbund einer Mehrzahl, d.h. von mindestens zwei, von Öffnungen, durch die die Ladungsträger hindurchtreten können, verstanden. Mit anderen Worten: Eine Gitterelektrode ist ein (im Allgemeinen) flächenförmiges Bauteil, dessen lateralen Abmessungen um ein Vielfaches größer als seine Dicke, d.h. seine Ausdehnung in Teilchenaustrittsrichtung, sind und das eine Vielzahl von Öffnungen aufweist, die sich in Dickenrichtung über die gesamte Dicke des Bauteils erstrecken und einen Durchtritt von Ladungsträgern durch das Bauteil ermöglichen. Die Gitterelektrode weist zumindest in einigen Bereichen ein elektrisch leitfähiges Material auf, das mit einem Potential beaufschlagt werden kann, so dass die Ladungsträger extrahiert und beschleunigt oder der oder die Teilstrahlen gesperrt werden können. Die elektrisch leitfähigen Gitterelektrodenbereiche können physisch und elektrisch leitend miteinander verbunden sein. Dies ist bspw. bei einer vollständig aus einem elektrisch leitfähigen Material ausgebildeten Gitterelektrode der Fall. Jedoch können die einzelnen elektrisch leitfähigen Gitterelektrodenbereiche auch elektrisch voneinander isoliert sein, bspw. durch ein dazwischen angeordnetes elektrisch isolierendes Material. In einer Vorrichtung zur Extraktion von elektrischen Ladungsträgern können mehrere Gitterelektroden in Teilchenaustrittsrichtung nacheinander in voneinander beabstandeten Lagen angeordnet werden, wobei die Öffnungen der einzelnen Gitterelektroden zueinander korrespondieren, so dass bei einer entsprechenden Potentialbeaufschlagung der einzelnen Gitterelektroden oder Gitterelektrodenbereiche Ladungsträger als Teilchenteilstrahlen durch die Öffnungen der Gitterelektroden hindurchtreten können. Oftmals werden mindestens drei Gitterelektroden eingesetzt, die als Plasma-, Screen- oder Beamgitterelektrode, als Beschleunigungs- oder Accelerationsgitterelektrode und als Massegitterelektrode entsprechend ihrer Funktion bezeichnet werden. Jedoch können auch weitere Elektroden in der Vorrichtung zur Extraktion von elektrischen Ladungsträgern angeordnet werden, um bspw. den erzeugten Teilchengesamtstrahl bezüglich seiner Austrittsrichtung zu beeinflussen.

Teilchenstrahlen werden bspw. in lonenstrahl- oder Elektronenstrahlbearbeitungsanlagen unter anderem zur Bearbeitung von Oberflächen eines Substrates eingesetzt. Dabei können die Topographie der Oberfläche oder andere physikalische oder chemische Eigenschaften der Oberfläche, wie bspw. hygroskopische Eigenschaften, durch das Auftreffen der Teilchen auf der Oberfläche verändert werden. Dabei hängen sowohl die erreichbare Auflösung, also die minimale bearbeitete Fläche, als auch die Qualität der Bearbeitung stark von der Strahlbreite des eingesetzten Gesamtstrahls ab. Im Allgemeinen gilt dabei, dass mit einer kleinen Strahlbreite bessere Bearbeitungsergebnisse erzielt werden. Beispielsweise können kleine Dickenunterschiede innerhalb einer auf der Oberfläche des Substrats befindlichen Schicht genauer mit einem Gesamtstrahl mit einer kleinen Strahlbreite eingeebnet werden als mit einem Gesamtstrahl mit einer großen Strahlbreite. Dem steht jedoch eine längere Bearbeitungsdauer eines Substrates mit einer gegebenen Fläche gegenüber.

Zur Lösung dieses Problems sind aus dem Stand der Technik verschiedene Möglichkeiten zur Formung eines lonenstrahls bekannt, bei denen die Breite oder Form des lonenstrahls an die notwendige Bearbeitungsqualität oder Bearbeitungsauflösung angepasst werden kann. Dies umfasst zum Einen die Nutzung verschiedener Blenden oder Gitterelektrodenanordnungen, mit denen ein Teil des lonenstrahls ausgeblendet werden kann bzw. erst gar nicht extrahiert wird. Zur Anpassung der Breite des lonenstrahls werden dann die Blende oder das bzw. die Gitter oder eventuell auch die gesamte Ionenstrahlquelle gewechselt, was jedoch zu Verunreinigungen durch die mechanische Bewegung führt oder lange Einlaufzeiten der neu installierten Ionenstrahlquelle nach sich zieht.

Des Weiteren ist die gezielte elektrische Steuerung einzelner lateraler Bereiche der Gitterelektrodenanordnung bekannt. So wird bspw. in der US 4,523,971 A beschrieben, dass jede Gitteröffnung einer Gitterelektrode separat so mit einem Potential beaufschlagt werden kann, dass der entsprechende Teilionenstrahl durchgelassen oder gesperrt wird. Jedoch führt dies neben einem hohen Verschaltungs- und Adressierungsaufwand zu einer geringen Ionenstromdichte, da gewisse Mindestabstände zwischen den einzelnen elektrischen Ansteuerungen der Gitterelektrodenöffnungen eingehalten werden müssen, was große Abstände der einzelnen Öffnungen voneinander nach sich zieht. In der US 4,758,304 A ist eine Gitterelektrode offenbart, bei der konzentrische Kreissegmente in einer leitenden Schicht ausgebildet sind, wobei die Kreissegmente an einer gemeinsamen Stelle unterbrochen sind und mittels Leiterbahnen, die in dieser Unterbrechung angeordnet sind, mit einem Potential beaufschlagt werden.

Nachteilig an diesen Vorrichtungen ist, dass elektrische Leitungen aus dem Inneren einer Gitterelektrode nach außen zu einer Spannungsversorgung geführt werden müssen. Bei den vorhandenen Potentialunterschieden von bis zu 1500 V zwischen den verschiedenen Gitterelektroden oder Gitterelektrodenbereichen sowie Temperaturen von bis zu 300°C, denen die Gitterelektroden während des Betriebs der Teilchenstrahlquelle ausgesetzt sind, stellt diese Art der Potentialbeaufschlagung eine große Herausforderung dar.

Aus der DE 10 2004 002 508 B4 sind zusätzliche Schaltgitter mit zeilenförmigen Segmenten bekannt, bei denen dieser Nachteil behoben ist. Hier ist es möglich, jedes zeilenförmige Segment von außen zu kontaktieren und einzeln elektrisch anzusteuern. Jedoch erfordert die Formung eines lonenstrahls mit einem nichtgeschlossenen Querschnittsprofil die Ansteuerung von mindestens zwei dieser Segmente.

Es ist daher Aufgabe der vorliegenden Erfindung, die Nachteile des Standes der Technik zu überwinden und eine einfache Möglichkeit zur Formung eines Teilchengesamtstrahls mit Hilfe von elektrisch schaltbaren Gitterelektroden bereitzustellen.

Diese Aufgabe wird durch die Vorrichtung zur Extraktion von elektrischen Ladungsträgern und das Verfahren zum Betreiben der Vorrichtung zur Extraktion von elektrischen Ladungsträgern gemäß den unabhängigen Ansprüchen gelöst. Darüber hinaus wird ein Verfahren zur Bearbeitung einer Oberfläche eines Substrates unter Nutzung einer solchen Vorrichtung zur Extraktion von elektrischen Ladungsträgern beansprucht. Vorteilhafte Weiterbildungen finden sich in den Unteransprüchen.

Eine erfindungsgemäße Vorrichtung zur Extraktion von elektrischen Ladungsträgern aus einem Ladungsträgererzeugungsraum umfasst mindestens eine Elektrodenanordnung, die mindestens eine erste Gitterelektrode und eine zweite Gitterelektrode mit korrespondierenden Öffnungen aufweist, die jeweils mindestens einen ersten Gitterelektrodenbereich enthalten, der elektrisch leitfähig ausgebildet ist. Die Öffnungen dienen dem Durchtritt der Ladungsträger durch die jeweilige Gitterelektrode in Teilchenaustrittsrichtung und weisen laterale Ausdehnungen und eine vorgegebene Umfangsgeometrie, bspw. eine runde, elliptische, eckige oder unregelmäßige Umfangsgeometrie, auf. Dabei können die lateralen Ausdehnungen und/oder die Umfangsgeometrien von zueinander korrespondierenden Öffnungen in der ersten und der zweiten Gitterelektrode geringfügig voneinander abweichen.

Erfindungsgemäß ist mindestens der mindestens eine erste Gitterelektrodenbereich der ersten Gitterelektrode in einer ersten Lage ausgebildet, während der mindestens eine erste Gitterelektrodenbereich der zweiten Gitterelektrode in einer zweiten Lage ausgebildet ist. Die erste Lage und die zweite Lage beschreiben jeweils eine Fläche innerhalb der Elektrodenanordnung, d.h. in dem Raum der Vorrichtung zur Extraktion von elektrischen Ladungsträgern, in dem die mindestens zwei Gitterelektroden angeordnet sind, wobei die erste Lage und die zweite Lage in Teilchenaustrittsrichtung nacheinander angeordnet und voneinander stets durch einen ersten Abstand entlang der Teilchenaustrittsrichtung beabstandet sind. Dabei können die erste Lage und die zweite Lage ebene oder gleichförmig oder ungleichförmig gekrümmte Flächen beschreiben, die beliebige Umfangsgeometrien in einer Projektion der Lage in Teilchenaustrittsrichtung haben können. Bspw. können die Lagen derart ausgebildet sein, dass die durch die Öffnungen in den Gitterelektroden hindurchtretenden einzelnen Teilstrahlen fokussiert, parallel zueinander ausgerichtet oder defokussiert werden. Darüber hinaus ist die Anordnung der zweiten Lage vor oder hinter der ersten Lage entlang der Teilchenaustrittsrichtung möglich.

Der mindestens eine erste Gitterelektrodenbereich der ersten Gitterelektrode bildet einen ersten elektrisch leitfähigen Lagenanteil der ersten Lage. Darüber hinaus ist in der ersten Lage ein zweiter elektrisch leitfähiger Lagenanteil ausgebildet, der durch mindestens einen zweiten elektrisch leitfähigen Gitterelektrodenbereich der ersten Gitterelektrode oder der zweiten Gitterelektrode gebildet wird. Der erste Lagenanteil und der zweite Lagenanteil sind voneinander elektrisch isoliert und erstrecken sich jeweils über die gesamte Dicke der ersten Lage, d.h. über die gesamte Ausdehnung der Lage in Teilchenaustrittsrichtung. Der zweite Lagenanteil ist elektrisch leitend mit dem mindestens einen ersten Gitterelektrodenbereich der zweiten Gitterelektrode verbunden.

Da der erste Lagenanteil von dem zweiten Lagenanteil elektrisch isoliert ist, können sie mit unterschiedlichen oder gleichen Potentialen beaufschlagt werden. Diese Beaufschlagung erfolgt für den zweiten Lagenanteil erfindungsgemäß über den mindestens einen ersten Gitterelektrodenbereich der zweiten Gitterelektrode. Damit entfällt eine von dem ersten Lagenanteil elektrisch isolierte Potentialzuführung des zweiten Lagenanteils innerhalb der ersten Lage.

Die erfindungsgemäße Vorrichtung zur Extraktion von Ladungsträgern stellt somit eine elektrisch schaltbare Extraktionsgitterelektrodenanordnung dar, mit deren Hilfe die Strahlcharakteristik eines Teilchenstrahls verändert werden kann.

Da die ersten Gitterelektrodenbereiche der ersten Gitterelektrode und der zweiten Gitterelektrode vorzugsweise so innerhalb der jeweiligen Gitterelektrode angeordnet sind, dass sie an den äußeren lateralen Umfang der jeweiligen Gitterelektrode angrenzen, wird somit ein vom äußeren lateralen Umfang der ersten Gitterelektrode beabstandeter zweiter Lagenanteil möglich, der ein von dem ersten Lagenanteil verschiedenes elektrisches Potential aufweist. Dabei werden weder elektrische Leitungen aus dem Inneren der ersten Gitterelektrode zum äußeren Umfang der ersten Gitterelektrode zur Potentialbeaufschlagung benötigt, noch wird eine aufwendige Ansteuerung von einem oder mehreren Segmenten einer Gitterelektrode notwendig.

In einer ersten Ausführungsform umfasst die erste Gitterelektrode nur den mindestens einen ersten Gitterelektrodenbereich, während die zweite Gitterelektrode mindestens einen zweiten Gitterelektrodenbereich aufweist, der den zweiten Lagenanteil der ersten Lage bildet. Mit anderen Worten: Die erste Gitterelektrode ist so ausgebildet, dass sie die erste Lage nicht vollständig abbildet, sondern mindestens eine Aussparung aufweist. Diese Aussparung kann an den lateralen Umfang der ersten Gitterelektrode angrenzen, d.h. am Rand der ersten Gitterelektrode ausgebildet sein, oder von diesem beabstandet sein, d.h. im Inneren der ersten Gitterelektrode ausgebildet sein. Der mindestens eine zweite Gitterelektrodenbereich der zweiten Gitterelektrode ist in der Aussparung und damit zumindest teilweise in der ersten Lage angeordnet. Der mindestens eine zweite Gitterelektrodenbereich der zweiten Gitterelektrode ist physisch und elektrisch leitend mit dem mindestens einen ersten Gitterelektrodenbereich der zweiten Gitterelektrode verbunden und ist vorzugsweise einstückig mit diesem ausgebildet.

Vorzugsweise ist der mindestens eine zweite Gitterelektrodenbereich der zweiten Gitterelektrode so dick ausgebildet, dass eine erste Oberfläche des mindestens einen zweiten Gitterelektrodenbereichs der zweiten Gitterelektrode sich in der ersten Lage befindet und eine zweite Oberfläche des mindestens einen zweiten Gitterelektrodenbereichs der zweiten Gitterelektrode, die der ersten Oberfläche gegenüberliegt, sich in der zweiten Lage befindet. Damit ist die zweite Gitterelektrode in dem mindestens einen zweiten Gitterelektrodenbereich wesentlich dicker ausgebildet als der mindestens eine erste Gitterelektrodenbereich der zweiten Gitterelektrode. Die zweite Gitterelektrode "ragt" damit in die erste Lage bzw. in die erste Gitterelektrode "hinein".

In einer anderen bevorzugten Ausgestaltung der ersten Ausführungsform weist der mindestens eine zweite Gitterelektrodenbereich der zweiten Gitterelektrode die selbe Dicke auf wie der mindestens eine erste Gitterelektrodenbereich der zweiten Gitterelektrode. Somit ist die zweite Gitterelektrode zumindest in den ersten und zweiten Gitterelektrodenbereichen gleich dick ausgebildet und so geformt, dass der mindestens eine zweite Gitterelektrodenbereich in der ersten Lage angeordnet ist. In den Übergangsbereichen zwischen dem mindestens einen ersten Gitterelektrodenbereich und dem mindestens einen zweiten Gitterelektrodenbereich kann die zweite Gitterelektrode eine größere oder kleinere Dicke aufweisen. Das bedeutet, dass die zweite Gitterelektrode in die erste Lage bzw. in die erste Gitterelektrode "hineingestülpt ist".

Vorzugsweise ist die zweite Gitterelektrode der ersten beiden Ausgestaltungen der ersten Ausführungsform derart ausgebildet, dass die Übergänge zwischen dem mindestens einen ersten Gitterelektrodenbereich der zweiten Gitterelektrode und dem mindestens einen zweiten Gitterelektrodenbereich der zweiten Gitterelektrode an beiden Oberflächen der zweiten Gitterelektrode stetig verlaufen. Dazu können die Übergänge bspw. abgerundet und/oder schräg ausgeführt werden. Damit werden Inhomogenitäten innerhalb des elektrischen Feldes zwischen der zweiten Gitterelektrode und Anordnungen mit einem anderen Potential, z.B. der ersten Gitterelektrode, einer weiteren Gitterelektrode oder auch dem Ladungsträgererzeugungsraum, verringert.

In einer weiteren bevorzugten Ausgestaltung der ersten Ausführungsform bildet der mindestens eine erste Gitterelektrodenbereich der zweiten Gitterelektrode die zweite Lage vollständig ab, während der mindestens eine zweite Gitterelektrodenbereich der zweiten Gitterelektrode zumindest in einigen lateralen Abschnitten des zweiten Gitterelektrodenbereichs von dem mindestens einen ersten Gitterelektrodenbereich der zweiten Gitterelektrode beabstandet ist. Mit anderen Worten: Die zweite Gitterelektrode bildet kein geschlossenes Gebilde, sondern besteht aus zwei Teilstücken, die elektrisch leitend in einigen lateralen Abschnitten des mindestens einen zweiten Gitterelektrodenbereiches miteinander verbunden sind. Der mindestens eine zweite Gitterelektrodenbereich der zweiten Gitterelektrode ist als physisch eigenständige Gitterelektrode ausgebildet, der aber elektrisch leitend, bspw. über elektrisch leitende Abstandshalter, mit dem mindestens einen ersten Gitterelektrodenbereich der zweiten Gitterelektrode, der die zweite Lage vollständig abbildet, verbunden ist.

In einer zweiten Ausführungsform umfasst die erste Gitterelektrode weiterhin mindestens einen zweiten Gitterelektrodenbereich, der den zweiten Lagenanteil der ersten Lage bildet. Damit ist die erste Gitterelektrode physisch einstückig ausgebildet und bildet die erste Lage vollständig ab, wobei jedoch der mindestens eine erste Gitterelektrodenbereich elektrisch von dem mindestens einen zweiten Gitterelektrodenbereich isoliert ist. Die zweite Gitterelektrode weist mindestens einen ersten Gitterelektrodenbereich auf, der in der zweiten Lage ausgebildet und elektrisch leitend mit dem mindestens einen zweiten Gitterelektrodenbereich der ersten Gitterelektrode verbunden ist. Vorzugsweise ist auch die zweite Gitterelektrode physisch einstückig ausgebildet und bildet die zweite Lage vollständig ab. Mit anderen Worten: Die erste Gitterelektrode und die zweite Gitterelektrode sind so ausgebildet, dass sie die erste Lage bzw. die zweite Lage vollständig abbilden und im Bereich des zweiten Lagenanteils elektrisch leitend miteinander verbunden sind.

Möglich ist auch eine Elektrodenanordnung, die mehrere laterale Bereiche umfasst, wobei in verschiedenen Bereichen verschiedene Ausführungsformen ausgebildet sind.

Vorzugsweise sind die Öffnungen für den Ladungsträgerdurchtritt in mindestens einem zweiten Gitterelektrodenbereich der ersten Gitterelektrode oder der zweiten Gitterelektrode gleich zu oder verschieden von den Öffnungen für den Ladungsträgerdurchtritt in mindestens einem ersten Gitterelektrodenbereich der zweiten Gitterelektrode bezüglich ihrer lateralen Ausdehnung und/oder ihrer Umfangsgeometrie. Mit der Anpassung der lateralen Ausdehnung und/oder der Umfangsgeometrie der Öffnungen im zweiten Gitterelektrodenbereich können unterschiedliche Beeinflussungen der Ladungsträger durch das elektrische Feld infolge des unterschiedlichen Abstandes der zweiten Gitterelektrodenbereiche zu einer Anordnung mit einem anderen Potential in Bezug auf den Abstand der ersten Gitterelektrodenbereiche der zweiten Gitterelektrode zur selben Anordnung mit einem anderen Potential oder infolge des Dickenunterschiedes zwischen den ersten Gitterelektrodenbereichen und den zweiten Gitterelektrodenbereichen der zweiten Gitterelektrode verringert werden.

In beiden Ausführungsformen kann der zweite Lagenanteil der ersten Lage durch einen zusammenhängenden zweiten Gitterelektrodenbereich der ersten oder der zweiten Gitterelektrode ausgebildet sein.

In einem anderen Fall kann der zweite Lagenanteil der ersten Lage auch durch mehrere voneinander beabstandete zweite Gitterelektrodenbereiche der ersten oder der zweiten Gitterelektrode ausgebildet sein. Dabei können die zweiten Gitterelektrodenbereiche gleiche oder unterschiedliche Umfangsgeometrien, d.h. Formen in der Projektion des Gitterelektrodenbereiches in Teilchenaustrittsrichtung, aufweisen. Bspw. sind runde, ellipsenförmige, drei-, vier- oder mehreckige Formen oder ungleichmäßige Formen möglich. Die zweiten Gitterelektrodenbereiche können gleichförmig oder ungleichförmig über die laterale Ausdehnung der ersten Lage verteilt sein. Bspw. können sie gleichförmig bezüglich einer Rotationsachse oder einer oder mehrerer Schnittlinien der ersten Lage angeordnet sein.

Darüber hinaus weist die mindestens eine Elektrodenanordnung vorzugsweise mindestens eine weitere, elektrisch leitfähige und mit korrespondierenden Öffnungen versehene Gitterelektrode auf. Jede dieser weiteren Gitterelektroden umfasst mindestens einen ersten Gitterelektrodenbereich in einer weiteren Lage. Die weitere Lage kann vor oder hinter der zweiten Lage entlang der Teilchenaustrittsrichtung im Elektrodenraum angeordnet sein, wobei die weitere Lage und die zu ihr benachbarte Lage, bspw. die zweite Lage, voneinander durch einen weiteren Abstand entlang der Teilchenaustrittsrichtung beabstandet sind. Die weitere Lage beschreibt eine zu der ersten und der zweiten Lage kongruente oder ähnliche Fläche.

Eine weitere Gitterelektrode ist vorzugsweise eine Massegitterelektrode. Jedoch können auch andere Gitterelektroden als weitere Gitterelektroden vorhanden sein.

Umfasst die mindestens eine Elektrodenanordnung mindestens eine weitere Gitterelektrode, die benachbart zur zweiten Gitterelektrode auf der von der ersten Gitterelektrode abgewandten Seite der zweiten Gitterelektrode angeordnet ist, und ist die zweite Gitterelektrode derart ausgestaltet, dass der mindestens eine zweite Gitterelektrodenbereich der zweiten Gitterelektrode die selbe Dicke aufweist wie der mindestens eine erste Gitterelektrodenbereich der zweiten Gitterelektrode, dann weist vorzugsweise diese weitere Gitterelektrode weiterhin mindestens einen zweiten Gitterelektrodenbereich auf, der in der zweiten Lage angeordnet und elektrisch leitend mit dem mindestens einen ersten Gitterelektrodenbereich der weiteren Gitterelektrode verbunden ist. Dabei korrespondiert die laterale Anordnung des mindestens einen zweiten Gitterelektrodenbereichs der weiteren Gitterelektrode innerhalb der zweiten Lage zu der lateralen Anordnung des mindestens einen zweiten Gitterelektrodenbereichs der zweiten Gitterelektrode innerhalb der ersten Lage. Auch weitere Gitterelektroden, die zu dieser weiteren Gitterelektrode benachbart sind, können Gitterelektrodenbereiche aufweisen, die in verschiedenen Lagen angeordnet sind. Mit anderen Worten: Auch weitere Gitterelektroden können in die jeweils benachbarte Gitterelektrode "hineingestülpt" sein bzw. in diese "hineinragen".

Die genannten ersten und zweiten Gitterelektrodenbereiche der ersten Gitterelektrode, der zweiten Gitterelektrode oder einer weiteren Gitterelektrode weisen jeweils die beschriebenen Öffnungen auf, die zu den Öffnungen in anderen Gitterelektroden korrespondieren. Darüber hinaus können eine oder mehrere oder alle Gitterelektroden der Elektrodenanordnung jeweils weitere Bereiche aufweisen, in denen keine Öffnungen ausgebildet sind. Diese Bereiche sind bspw. Randbereiche, die zur Halterung der jeweiligen Gitterelektrode in der Elektrodenanordnung und/oder zur elektrischen Kontaktierung der mit diesem Bereich elektrisch leitend verbundenen Gitterelektrodenbereiche der jeweiligen Gitterelektrode dienen.

In einer besonderen Ausführungsform weist die Vorrichtung zur Extraktion von elektrischen Ladungsträgern mehrere Elektrodenanordnungen zur Extraktion von Ladungsträgern auf, wobei eine oder mehrere der Elektrodenanordnungen nebeneinander in einer ersten Richtung entlang der lateralen Ausdehnung der Vorrichtung zur Extraktion von elektrischen Ladungsträgern und höchstens zwei Elektrodenanordnungen nebeneinander in einer zweiten Richtung entlang der lateralen Ausdehnung der Vorrichtung zur Extraktion von elektrischen Ladungsträgern angeordnet sind, so dass die Elektrodenanordnungen nahezu die gesamte laterale Ausdehnung der Vorrichtung zur Extraktion von elektrischen Ladungsträgern abdecken. Lediglich Randbereiche der Vorrichtung zur Extraktion von elektrischen Ladungsträgern und/oder Bereiche zwischen benachbarten Elektrodenanordnungen können hiervon ausgenommen sein. Da die mehreren Elektrodenanordnungen höchstens in einer *nx*2-Matrix angeordnet sind, können alle Elektrodenanordnungen von außen zur Beaufschlagung mit definierten Potentialen kontaktiert werden. Damit sind keine elektrischen Zuleitungen im Inneren der lateralen Ausdehnung der Vorrichtung zur Extraktion von elektrischen Ladungsträgern notwendig und die Ansteuerung der einzelnen Elektrodenanordnungen wird vereinfacht. Die laterale Ausdehnung der Vorrichtung zur Extraktion von elektrischen Ladungsträgern ist die Ausdehnung der Vorrichtung zur Extraktion von elektrischen Ladungsträgern in der Fläche, in der die Ladungsträger mit Hilfe der mindestens einen Elektrodenanordnung aus einem Ladungsträgererzeugungsraum, bspw. einem Plasma, extrahiert werden können. Das heißt, die laterale Ausdehnung ist senkrecht zur Teilchenaustrittsrichtung definiert. Die mehreren Elektrodenanordnungen können gleiche oder unterschiedliche Muster der zweiten Lagenanteile aufweisen. Unter Muster sollen hier sowohl die eine oder mehreren Umfangsgeometrien des mindestens einen zweiten Gitterelektrodenbereiches sowie die laterale Anordnung des mindestens einen zweiten Gitterelektrodenbereiches in einer spezifischen Elektrodenanordnung verstanden werden.

Vorzugsweise ist bzw. sind eine, mehrere oder alle der in der Elektrodenanordnung enthaltenen Gitterelektroden einzeln aus einer Halterung der Elektrodenanordnung oder von einer der anderen Gitterelektroden lösbar angeordnet. Damit können einzelne Gitterelektroden, die bspw. einen höheren Verschleiß durch thermische, mechanische oder elektrische Beanspruchung aufweisen, einzeln aus der Elektrodenanordnung entnommen und ausgewechselt bzw. durch neue Gitterelektroden ersetzt werden. Werden die erste und die zweite Gitterelektrode ausgewechselt und durch entsprechende Gitterelektroden ersetzt, die ein anderes Muster aufweisen, so kann eine neue Vorrichtung zur Extraktion von elektrischen Ladungsträgern geschaffen werden, die eine neue, andere Strahlcharakteristik des erzeugbaren Teilchenstrahls ermöglicht.

In einer bevorzugten Ausführungsform umfasst die mindestens eine Elektrodenanordnung in Teilchenaustrittsrichtung nacheinander eine Plasmagitterelektrode, eine Schaltgitterelektrode und eine Beschleunigungsgitterelektrode, wobei die Schaltgitterelektrode die erste Gitterelektrode und die Plasmagitterelektrode oder die Beschleunigungsgitterelektrode die zweite Gitterelektrode ist. Dabei bedeutet "nacheinander" nur, dass die genannten Gitterelektroden in der genannten Reihenfolge angeordnet sind. Zwischen der Schaltgitterelektrode und der Gitterelektrode, die nicht die zweite Gitterelektrode ist, können weitere Gitterelektroden angeordnet sein.

Bei einem erfindungsgemäßen Verfahren zum Betreiben einer erfindungsgemäßen Vorrichtung zur Extraktion von elektrischen Ladungsträgern mit einer Plasmagitterelektrode, einer Schaltgitterelektrode und einer Beschleunigungsgitterelektrode, bei dem die Schaltgitterelektrode die erste Gitterelektrode und die Plasmagitterelektrode oder die Beschleunigungsgitterelektrode die zweite Gitterelektrode ist, wird in Abhängigkeit von einer gewünschten Strahlcharakteristik des durch eine der mindestens einen Elektrodenanordnung hindurchtretenden Teilchenstrahls jede der mindestens einen Elektrodenanordnung derart mit Hilfe einer Vorrichtung zur Erzeugung einer oder mehrerer elektrischer Spannungen sowie einer Schaltvorrichtung angesteuert, dass der mindestens eine erste Gitterelektrodenbereich der Schaltgitterelektrode der spezifischen Elektrodenanordnung mit einem ersten Potential und die Beschleunigungsgitterelektrode der spezifischen Elektrodenanordnung mit einem zweiten Potential beaufschlagt werden. Die Werte des ersten und des zweiten Potentials sind in den einzelnen Schaltzuständen der Vorrichtung zur Extraktion von elektrischen Ladungsträgern dabei so gewählt, dass sie einen Durchtritt der Ladungsträger durch die entsprechenden Gitterelektrodenbereiche erlauben oder die entsprechenden Gitterelektrodenbereiche für den Ladungsträgerdurchtritt sperren, und beziehen sich immer auf den Potentialwert der Plasmagitterelektrode bzw. des Ladungsträgererzeugungsraums. Die Werte des ersten und des zweiten Potentials für einen Ladungsträgerdurchtritt sind dabei für positive Ladungsträger immer negativer als das Potential der Plasmagitterelektrode und für negative Ladungsträger positiver als dieses. Die Werte des ersten und des zweiten Potentials für eine Sperrung des Ladungsträgerdurchtritts sind hingegen für positive Ladungsträger höhere positive Werte als das Potential der Plasmagitterelektrode bzw. des Ladungsträgererzeugungsraums, während für negative Ladungsträger dies höhere negative Werte sind. Die einzelnen konkreten Potentialwerte für die Schaltgitterelektrode und die Beschleunigungsgitterelektrode hängen also von der Ladungsträgerart und -polarität sowie von der konkreten Ausgestaltung der Vorrichtung zur Extraktion von elektrischen Ladungsträgern und des Ladungsträgererzeugungsraums ab.

In einem ersten Schaltzustand weisen das erste Potential einen ersten Wert U₁₁ und das zweite Potential einen zweiten Wert U₂₁ auf, die beide geeignet sind, den Durchtritt von Ladungsträgern durch die entsprechenden Gitterelektrodenbereiche zu ermöglichen. Dabei können der erste Wert U₁₁ und der zweite Wert U₂₁ gleich oder nahezu gleich sein oder wesentlich voneinander abweichen, solange der Ladungsträgerdurchtritt gewährleistet ist. Mit diesem ersten Schaltzustand wird die gesamte laterale Ausdehnung der Elektrodenanordnung zur Extraktion von Ladungsträgern freigegeben, so dass ein Gesamtstrahl mit einer großen lateralen Ausdehnung erzeugt wird.

In einem zweiten Schaltzustand weisen das erste Potential einen dritten Wert U₁₂, der einen Ladungsträgerdurchtritt durch die zu dem ersten Lagenanteil korrespondierenden Gitterelektrodenbereiche der Schaltgitterelektrode und der Beschleunigungsgitterelektrode verhindert, und das zweite Potential einen vierten Wert U₂₂, der den Durchtritt von Ladungsträgern durch die zu dem zweiten Lagenanteil korrespondierenden Gitterelektrodenbereiche in der Schaltgitterelektrode und der Beschleunigungsgitterelektrode ermöglicht, auf. Damit wird der erste Lagenanteil für die Extraktion von Ladungsträgern elektrisch ausgeblendet, wodurch ein oder mehrere Teilstrahlen mit jeweils einer kleinen lateralen Ausdehnung erzeugt werden.

In einem dritten Schaltzustand weisen das erste Potential einen fünften Wert U₁₃ und das zweite Potential einen sechsten Wert U₂₃ auf, die beide den Ladungsträgerdurchtritt durch die entsprechenden Gitterelektrodenbereiche verhindern. Dabei können der fünfte Wert U₁₃ und der sechste Wert U₂₃ gleich, nahezu gleich oder verschieden sein. Damit wird die Extraktion von Ladungsträgern über die gesamte laterale Ausdehnung der Elektrodenanordnung verhindert und kein Teilchenstrahl erzeugt.

Für die konkreten Werte der Potentiale gilt, dass diese an die jeweilige Konfiguration der Elektrodenanordnung und den jeweiligen Schaltzustand angepasst werden. Damit können bspw. der dritte Wert U₁₂ und der fünfte Wert U₁₃, die beide den Ladungsträgerdurchtritt durch den mindestens einen ersten Gitterelektrodenbereich der Schaltgitterelektrode verhindern, gleich, nahezu gleich oder verschieden sein. Ähnliches gilt für den zweiten Wert U₂₁ und den vierten Wert U₂₂, die beide den Ladungsträgerdurchtritt durch die Gitterelektrodenbereiche der Beschleunigungsgitterelektrode erlauben.

Vorzugsweise werden das erste Potential und/oder das zweite Potential gepulst beaufschlagt. Dabei können die Pulslängen und/oder die Pulsverhältnisse der jeweiligen Potentiale gleich oder voneinander verschieden sein. Ebenfalls möglich ist eine zeitliche Variation der Pulslänge und/oder des Pulsverhältnisses der jeweiligen Potentiale.

Vorzugsweise wird die Plasmagitterelektrode mit einem dritten Potential U_{beam} beaufschlagt, dessen Polarität von den zu extrahierenden Ladungsträgern abhängt. In einer anderen Ausführungsform wird die Plasmagitterelektrode nicht mit einem definierten Potential beaufschlagt, so dass das Potential der Plasmagitterelektrode floatet und im Wesentlichen vom Potential einer zusätzlichen Plasmaelektrode im Ladungsträgererzeugungsraum bestimmt wird.

Weist die Elektrodenanordnung in Teilchenaustrittsrichtung nach der Beschleunigungsgitterelektrode eine elektrisch leitfähige und mit korrespondierenden Öffnungen versehene Massegitterelektrode auf, die mindestens einen ersten Gitterelektrodenbereich in einer dritten Lage umfasst, wobei die zweite Lage und die dritte Lage voneinander durch einen zweiten Abstand entlang der Teilchenaustrittsrichtung beabstandet sind, so wird die Massegitterelektrode vorzugsweise geerdet.

Umfasst die Vorrichtung zur Extraktion von elektrischen Ladungsträgern mehrere derartige Elektrodenanordnungen, so wird jede der mehreren Elektrodenanordnungen wie oben beschrieben angesteuert, so dass der mindestens eine aus der gesamten Vorrichtung zur Extraktion von elektrischen Ladungsträgern austretende Teilchenstrahl eine gewünschte Strahlcharakteristik aufweist.

Erfindungsgemäß werden eine oder mehrere der oben beschriebenen erfindungsgemäßen Vorrichtung zur Extraktion von elektrischen Ladungsträgern zur Bearbeitung der Oberfläche eines Substrates unter Nutzung eines oder mehrerer Teilchenstrahlen aus mindestens einer Vorrichtung zur Extraktion von elektrischen Ladungsträgern derart verwendet, dass während der Bearbeitung des Substrates in Abhängigkeit von einem bekannten Eigenschaftsmuster der Substratoberfläche und vom Verfahrensfortschritt die Strahlcharakteristik des einen oder von mehreren Teilchenstrahlen aus der mindestens einen Vorrichtung zur Extraktion von elektrischen Ladungsträgern mit Hilfe des erfindungsgemäßen Verfahrens zum Betreiben der Vorrichtung zur Extraktion von elektrischen Ladungsträgern in gewünschter Weise verändert wird. Unter einem Eigenschaftsmuster der Substratoberfläche werden die auf definierte Flächenbereiche der Substratoberfläche bezogenen physikalischen und/oder chemischen Eigenschaften sowie die Oberflächentopografie verstanden, die eine durch die Herstellung oder eine vorherige Prozessierung des Substrates verursachte Verteilung über die gesamte Substratoberfläche hinweg aufweisen. Die Substratoberfläche wird durch das Auftreffen der elektrischen Ladungsträger beeinflusst. Dabei kann Material von der Substratoberfläche abgetragen oder auf dieser aufgetragen werden oder die chemischen oder physikalischen Eigenschaften des Materials der Substratoberfläche werden verändert, so dass eine Reaktion mit anderen Stoffen ermöglicht oder verhindert wird. Auch die Beeinflussung von hygroskopischen, optischen, kristallographischen, elektrischen, magnetischen oder anderen physikalischen Eigenschaften ist möglich.

Vorzugsweise werden zur Bearbeitung der Oberfläche eines Substrates Ionen eingesetzt, so dass die Vorrichtung zur Extraktion von elektrischen Ladungsträgern eine Ionenstrahlquelle ist.

Vorzugsweise werden bei dem Verfahren zur Bearbeitung der Oberfläche eines Substrates eine oder mehrere Vorrichtungen zur Extraktion von elektrischen Ladungsträgern so gesteuert, dass gleichzeitig mehrere Teilchenstrahlen auf das Substrat auftreffen, wobei die mehreren Teilchenstrahlen gleiche oder verschiedene Strahlcharakteristiken aufweisen.

Vorzugsweise werden eine oder mehrere Vorrichtungen zur Extraktion von elektrischen Ladungsträgern so gesteuert, dass mehrere Teilchenstrahlen auf eine gemeinsame Fläche auf der Substratoberfläche auftreffen, wobei die mehreren Teilchenstrahlen unterschiedliche Strahlcharakteristiken aufweisen und wobei die gemeinsame Fläche in etwa der Auftrefffläche desjenigen auftreffenden Teilchenstrahls, der die größte Auftrefffläche aller auftreffenden Teilchenstrahlen aufweist, entspricht. Damit ist bspw. das Ausbilden von Strukturen mit unterschiedlichen Höhen bzw. Tiefen innerhalb einer Struktur und/oder mit unterschiedlichen bzw. ungleichmäßigen Formen in nur einem Bearbeitungsvorgang möglich. Dabei können sich die Strahlcharakteristiken hinsichtlich der lateralen Ausdehnung bzw. des Musters des jeweiligen Teilchenstrahls und/oder hinsichtlich des Fokus, der Teilchendichte, der Teilchenart oder anderer Merkmale unterscheiden.

Im Nachfolgenden soll die Erfindung anhand von Ausführungsbeispielen und Figuren verdeutlicht werden.

Es zeigen:
Fig. 1 eine schematische Darstellung einer Vorrichtung (1) zur Extraktion von elektrischen Ladungsträgern aus einem Ladungsträgererzeugungsraum (2) mit zwei Elektrodenanordnungen (1a, 1 b), die in einer Teilchenstrahlquelle (3) anordnet ist.
Fig. 2A einen Querschnitt durch eine Elektrodenanordnung (1a') nach dem Stand der Technik, die eine Plasmagitterelektrode (11'), eine Schaltgitterelektrode (12'), eine Beschleunigungsgitterelektrode (13') und eine Massegitterelektrode (14') aufweist.
Fig. 2B eine Draufsicht auf die Elektrodenanordnung (1a') nach Fig. 2A.

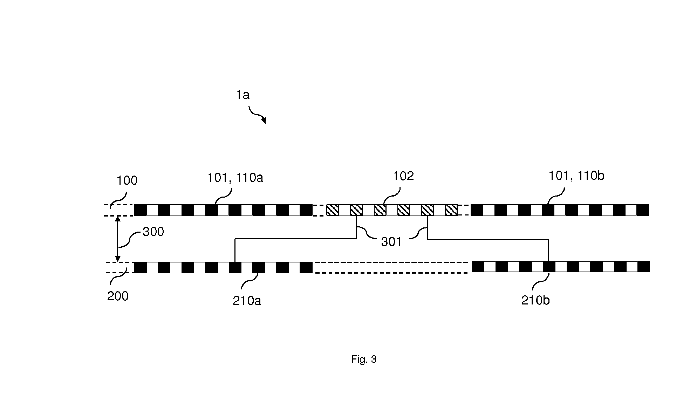

Fig. 3 eine Elektrodenanordnung (1a) gemäß der vorliegenden Erfindung im Querschnitt, wobei erste Gitterelektrodenbereiche (110a, 110b) einer ersten Gitterelektrode (110) in einer ersten Lage (100) und erste Gitterelektrodenbereiche (210a, 210b) einer zweiten Gitterelektrode (210) in einer zweiten Lage (200) ausgebildet sind. Die ersten Gitterelektrodenbereiche (110a, 110b) bilden einen ersten Lagenanteil (101) der ersten Lage (100), in der darüber hinaus ein zweiter Lagenanteil (102) ausgebildet ist, der elektrisch von dem ersten Lagenanteil (101) isoliert und elektrisch leitend mit den ersten Gitterelektrodenbereichen (210a, 210b) der zweiten Gitterelektrode verbunden ist.
Fig. 4 eine erste Ausgestaltung einer ersten Ausführungsform der erfindungsgemäßen Elektrodenanordnung (1a) im Querschnitt, bei der der zweite Lagenanteil (102) durch einen zweiten Gitterelektrodenbereich (210c) der zweiten Gitterelektrode ausgebildet ist.
Fig. 5 eine zweite Ausgestaltung der ersten Ausführungsform der erfindungsgemäßen Elektrodenanordnung (1a) im Querschnitt.
Fig. 6 einen stetigen Verlauf des Übergangs zwischen den ersten Gitterelektrodenbereichen (210a, 210b) der zweiten Gitterelektrode und dem zweiten Gitterelektrodenbereich (210c) der zweiten Gitterelektrode in einer beispielhaften Ausgestaltung im Querschnitt.
Fig. 7 eine dritte Ausgestaltung der ersten Ausführungsform der erfindungsgemäßen Elektrodenanordnung (1a) im Querschnitt.
Fig. 8 eine zweite Ausführungsform der erfindungsgemäßen Elektrodenanordnung (1a) im Querschnitt, bei der der zweite Lagenanteil (102) durch einen zweiten Gitterelektrodenbereich (110c) der ersten Gitterelektrode ausgebildet ist.
Fig. 9A bis 9D verschiedene Muster des zweiten Lagenanteils (102) innerhalb der ersten Lage (100) in der Draufsicht.
Fig. 10 eine Ausführungsform der erfindungsgemäßen Elektrodenanordnung (1a) mit zwei weiteren Gitterelektroden (401, 402) im Querschnitt.
Fig. 11 eine Ausführungsform der erfindungsgemäßen Elektrodenanordnung (1a), bei der die einzelnen Lagen gekrümmte Flächen sind, so dass die Teilchenteilstrahlen (8) fokussiert werden.
Fig. 12 eine Ausführungsform der erfindungsgemäßen Vorrichtung (1) zur Extraktion von elektrischen Ladungsträgern mit acht Elektrodenanordnungen (1a - 1 h) in der Draufsicht.
Fig. 13A bis 13C verschiedene Beschaltungszustände einer Ausführungsform der erfindungsgemäßen Elektrodenanordnung (1a), bei der die Schaltgitterelektrode (12) die erste Gitterelektrode (110) und die Beschleunigungsgitterelektrode (13) die zweite Gitterelektrode (210) ist.
Fig. 14 eine Anordnung zur Bearbeitung einer Oberfläche eines Substrates (9) mit einem Teilchenstrahl (20), der mit Hilfe der erfindungsgemäßen Vorrichtung (1) zur Extraktion von elektrischen Ladungsträgern erzeugt wurde.
Fig. 15 eine Anordnung gemäß Fig. 14, bei der mehrere Teilchenstrahlen gleichzeitig auf die Substratoberfläche auftreffen.
Fig. 16 eine Anordnung gemäß Fig. 15, bei der die mehreren Teilchenstrahlen auf eine gemeinsame Fläche auf der Substratoberfläche auftreffen.

### Ausführungsbeispiele

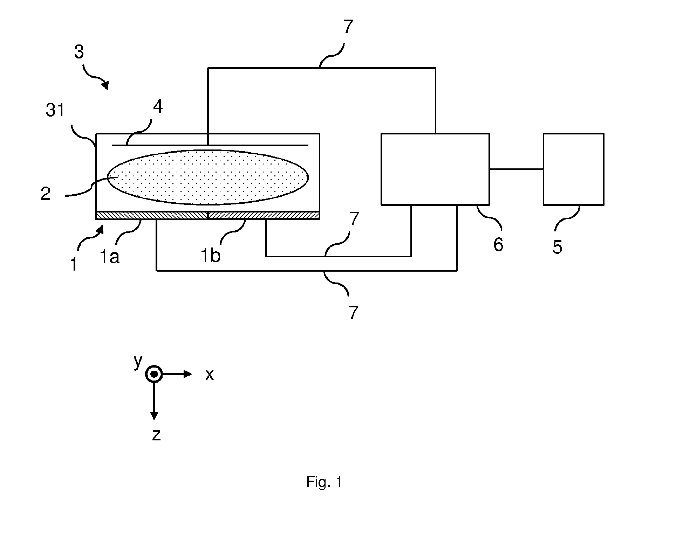

**Fig. 1** zeigt schematisch eine Vorrichtung (1) zur Extraktion von elektrischen Ladungsträgern aus einem Ladungsträgererzeugungsraum (2). Dieser Ladungsträgererzeugungsraum (2) ist bspw. ein Plasma, das innerhalb eines Gehäuses (31) einer Teilchenstrahlquelle (3) mit Hilfe einer oder mehrerer Elektroden (4) erzeugt wurde. Häufig werden auch elektrodenlose Vorrichtungen zur Plasmaerzeugung, wie bspw. induktiv gekoppelte Plasmaquellen oder mikrowellen-gestützte Quellen unter Nutzung des ECR-Effektes, eingesetzt. Auch Hot-filament-Quellen können zum Einsatz kommen. Der Plasmaraum, d.h. der Raum, in dem das Plasma erzeugt wird, kann bspw. topfförmig oder wannenartig oder anderweitig wie aus dem Stand der Technik bekannt ausgebildet sein. Darüber hinaus können die zu extrahierenden Ladungsträger auch anderweitig erzeugt werden, so dass der Ladungsträgererzeugungsraum (2) kein Plasma ist. Bspw. können Elektronenkanonen oder Ionenkanonen zum Einsatz kommen oder Targets können unter Erzeugung von Ionen zerstäubt werden. Die konkrete Ausgestaltung des Ladungsträgererzeugungsraumes (2) ist frei wählbar, solange ein ausreichender Vorrat an elektrischen Ladungsträgern an der Vorrichtung (1) zur Extraktion von elektrischen Ladungsträgern vorliegt, Die Vorrichtung (1) zur Extraktion von elektrischen Ladungsträgern ist in oder an der Teilchenstrahlquelle (3) angeordnet und umfasst eine oder mehrere Elektrodenanordnungen (1a, 1b). Dabei werden die eine oder mehreren Elektroden (4) zur Erzeugung der Ladungsträger sowie die Vorrichtung (1) zur Extraktion der Ladungsträger mit Hilfe einer Vorrichtung (5) zur Erzeugung einer oder mehrerer elektrischer Spannungen über eine Schaltvorrichtung (6) und entsprechende elektrische Leitungen (7) mit Potentialen beaufschlagt.

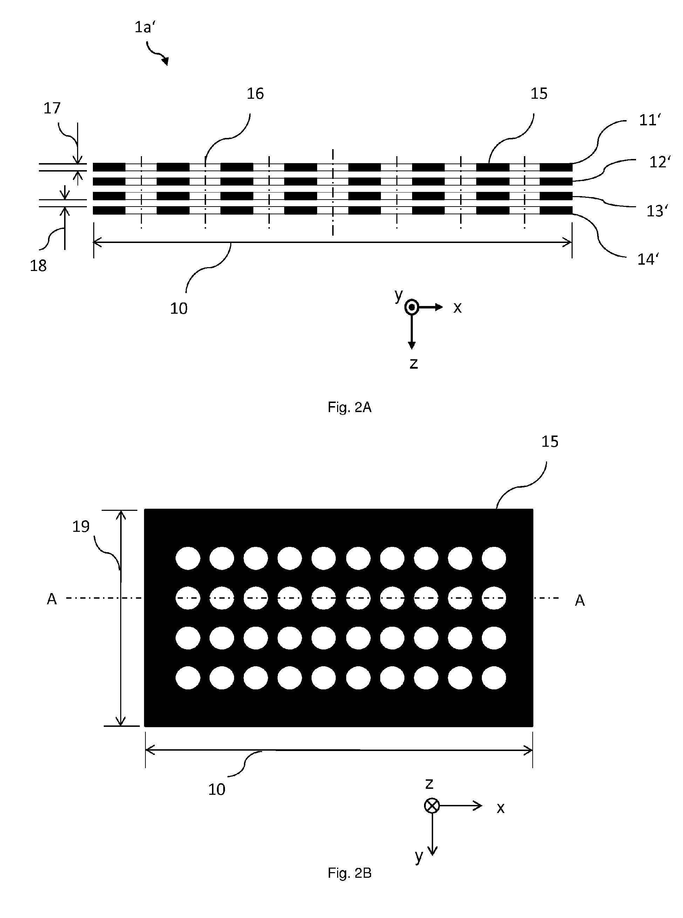

Die Elektrodenanordnungen (1a, 1b) bestehen in der Regel aus einer oder mehreren Gitterelektroden. **Fig. 2A** zeigt eine Elektrodenanordnung (1a') nach dem Stand der Technik im Querschnitt, während **Fig. 2B** eine Gitterelektrode in der Draufsicht zeigt. (Die Linie A-A in Fig. 2B markiert die Schnittlinie der Darstellung von Fig. 2A.) Die Elektrodenanordnung (1a') nach dem Stand der Technik weist eine Plasmagitterelektrode (11'), eine Schaltgitterelektrode (12'), eine Beschleunigungsgitterelektrode (13') und eine Massegitterelektrode (14') auf. Jede dieser Gitterelektroden besteht aus einem elektrisch leitfähigen Gitterelektrodenmaterial (15) und weist Öffnungen (16) auf, durch die die extrahierten elektrischen Ladungsträger, im Folgenden kurz Teilchen genannt, in z-Richtung hindurchtreten können. Die z-Richtung ist damit die Teilchenaustrittsrichtung. Das heißt, die Öffnungen (16) erstrecken sich von einer Oberfläche der Gitterelektrode bis zur gegenüberliegenden Oberfläche der Gitterelektrode, wobei die Öffnung gerade oder schräg verlaufen kann. Als Gitterelektrodenmaterial kommen Metalle, bspw. Molybdän oder Wolfram, oder Graphite zur Anwendung, wobei das Gitterelektrodenmaterial auch eine Schichtfolge aus mehreren elektrisch leitenden Materialien oder auch aus einem elektrisch nichtleitenden Grundkörper mit einer Beschichtung aus einem elektrisch leitenden Material sein kann. Die Öffnungen (16) können verschiedene Umfangsgeometrien aufweisen, bspw. können sie rund, elliptisch oder vieleckig sein, verschiedene Abmessungen aufweisen und/oder gleichförmig oder ungleichmäßig über die laterale Ausdehnung der Gitterelektrode in der x-y-Ebene verteilt sein. Die Öffnungen (16) haben bspw. einen Lochdurchmesser von 0,5 mm bis 3 mm, während das Gitterelektrodenmaterial (15) typisch eine Stegbreite, d.h. eine Breite zwischen zwei benachbarten Öffnungen (16), von 0,5 mm bis 1 mm aufweist. Die Verteilung der Öffnungen (16) über die gesamte laterale Ausdehnung einer Gitterelektrode hinweg kann dabei derart ausgestaltet sein, dass eine homogene Verteilung der Stromdichte im Teilchenstrahl oder in ausgewählten Bereichen des Teilchenstrahls erreicht wird. Darüber hinaus kann mit der Dichte der Anordnung von Öffnungen (16), d.h. mit der Wahl der Stegbreite zwischen benachbarten Öffnungen (16), die erreichbare Stromdichte in einem korrespondierenden Bereich des Teilchenstrahls eingestellt werden. So wird bspw. durch eine dichte Anordnung von Öffnungen (16), d.h. kleine Stegbreiten, eine hohe Stromdichte erreicht.

Jede Gitterelektrode weist eine erste laterale Ausdehnung (10) in x-Richtung, eine zweite laterale Ausdehnung (19) in y-Richtung und eine Dicke (17) in z-Richtung auf, wobei die erste laterale Ausdehnung (10) und die zweite laterale Ausdehnung (19) von einigen mm bis zu einigen Metern und die Dicke (17) typisch 200 µm bis zu 1 mm betragen kann. Bei sehr großer lateraler Ausdehnung der Gitter kann es aber auch erforderlich sein, dickere Gitter, z.B. von einigen Millimetern Dicke, einzusetzen. Die Gitterelektroden können eine beliebige Umfangsgeometrie aufweisen, die bspw. rechteckig, rund, elliptisch oder vieleckig sein kann. Vorzugsweise sind alle Gitterelektroden einer Elektrodenanordnung gleichartig ausgebildet oder weisen nur geringe Unterschiede in den genannten Parametern auf. Die einzelnen Gitterelektroden weisen einen Abstand (18) zueinander auf, der typisch zwischen 0,5 mm und 1,5 mm beträgt und vorzugsweise zwischen allen Gitterelektroden gleich ist. Die genannten Gitterelektrodenparameter werden entsprechend der mechanischen, elektrischen und thermischen Beanspruchung der Gitterelektroden gewählt. Die Gitterelektroden sind jeweils in einer Lage ausgebildet, die entweder eben ist, wie in der Fig. 2A dargestellt, oder einen Krümmungsradius aufweist, wobei jedoch der Abstand zwischen den einzelnen Gitterelektroden stets ungefähr gleich bleibt. Charakteristisch ist, dass jede Gitterelektrode nur in einer Lage ausgebildet ist und jede Lage elektrisch vollständig von den anderen Lagen isoliert ist.

Demgegenüber ist eine erfindungsgemäße Elektrodenanordnung (1a), wie sie in **Fig. 3** dargestellt ist, durch eine elektrisch leitende Verbindung zwischen einem Gitterelektrodenbereich, der einen Lagenanteil einer ersten Lage bildet, und einem Gitterelektrodenbereich, der in einer zweiten Lage ausgebildet ist, charakterisiert, wobei der Gitterelektrodenbereich in der ersten Lage elektrisch isoliert von anderen Gitterelektrodenbereichen in der ersten Lage ist. Fig. 3 zeigt eine schematische Darstellung dieser Anordnung. Es sind eine erste Lage (100) und eine zweite Lage (200) dargestellt, die mit gestrichelten Linien symbolisiert sind und jeweils eine geschlossene Fläche bilden. Die erste Lage (100) und die zweite Lage (200) sind durch einen ersten Abstand (300) voneinander beabstandet. In der ersten Lage (100) ist eine erste Gitterelektrode angeordnet, die erste Gitterelektrodenbereiche (110a, 110b) aufweist. Diese Gitterelektrodenbereiche (110a, 110b) bilden den ersten Lagenanteil (101) der ersten Lage (100). In der zweiten Lage (200) ist eine zweite Gitterelektrode angeordnet, die erste Gitterelektrodenbereiche (210a, 210b) aufweist. In der ersten Lage (100) ist darüber hinaus ein weiterer Gitterelektrodenbereich (schraffiert dargestellt) angeordnet, der einen zweiten Lagenanteil (102) der ersten Lage (100) bildet und der elektrisch isoliert von dem ersten Lagenanteil (101) der ersten Lage (100), jedoch elektrisch leitend mit den ersten Gitterelektrodenbereichen (210a, 210b) der zweiten Gitterelektrode in der zweiten Lage (200) verbunden ist. Diese elektrische Verbindung ist schematisch durch die Striche mit dem Bezugszeichen 301 dargestellt, wobei die elektrische Verbindung (301) keine elektrische Leitung im Sinne einer Drahtbrücke o.ä. sein muss.

Wie in Fig. 3 zu sehen ist, kann der zweite Lagenanteil (102) vom Umfang der ersten Lage (100) beabstandet sein, d.h. sich im Inneren der ersten Lage (100) befinden. Trotzdem ist über die elektrische Verbindung (301) mit den ersten Gitterelektrodenbereichen (210a, 210b) der zweiten Gitterelektrode, die an den Umfang der zweiten Lage (200) angrenzen, eine Beaufschlagung des zweiten Lagenanteils (102) mit einem elektrischen Potential, das vom elektrischen Potential des ersten Lagenanteils (101) verschieden ist, über einen elektrischen Kontakt an der äußeren Begrenzung, d.h. dem Umfang, der Elektrodenanordnung (1a) möglich.

In der zweiten Lage (200) können neben den ersten Gitterelektrodenbereichen (210a, 210b) der zweiten Gitterelektrode noch weitere Gitterelektrodenbereiche der zweiten Gitterelektrode oder Gitterelektrodenbereiche einer weiteren Gitterelektrode ausgebildet sein. Es ist auch möglich, dass sich die ersten Gitterelektrodenbereiche (210a, 210b) der zweiten Gitterelektrode durchgängig über die gesamte zweite Lage (200) erstrecken. Zur übersichtlichen Darstellung der erfindungsgemäßen Grundidee sind in Fig. 3 nur die ersten Gitterelektrodenbereiche (210a, 210b) der zweiten Gitterelektrode dargestellt, während weitere Bereiche in der zweiten Lage (200) weggelassen wurden.

Die Ausgestaltung der elektrischen Verbindung (301) sowie der ersten Gitterelektrode und der zweiten Gitterelektrode wird im Folgenden anhand einiger Ausführungsbeispiele erläutert, wobei auf die Darstellung der Öffnungen (16) in den einzelnen Gitterelektroden zur besseren Übersichtlichkeit verzichtet wird. Auch wird jeweils nur ein Gitterelektrodenbereich, der den zweiten Lagenanteil bildet, gezeigt, wobei die Anzahl dieser Gitterelektrodenbereiche nicht begrenzt ist.

In einer ersten Ausführungsform der erfindungsgemäßen Elektrodenanordnung (1a) weist die erste Gitterelektrode nur die ersten Gitterelektrodenbereiche (110a, 110b) auf und bildet damit nicht die gesamte erste Lage (100) ab, während der zweite Lagenanteil (102) der ersten Lage (100) durch einen zweiten Gitterelektrodenbereich (210c) der zweiten Gitterelektrode gebildet wird.

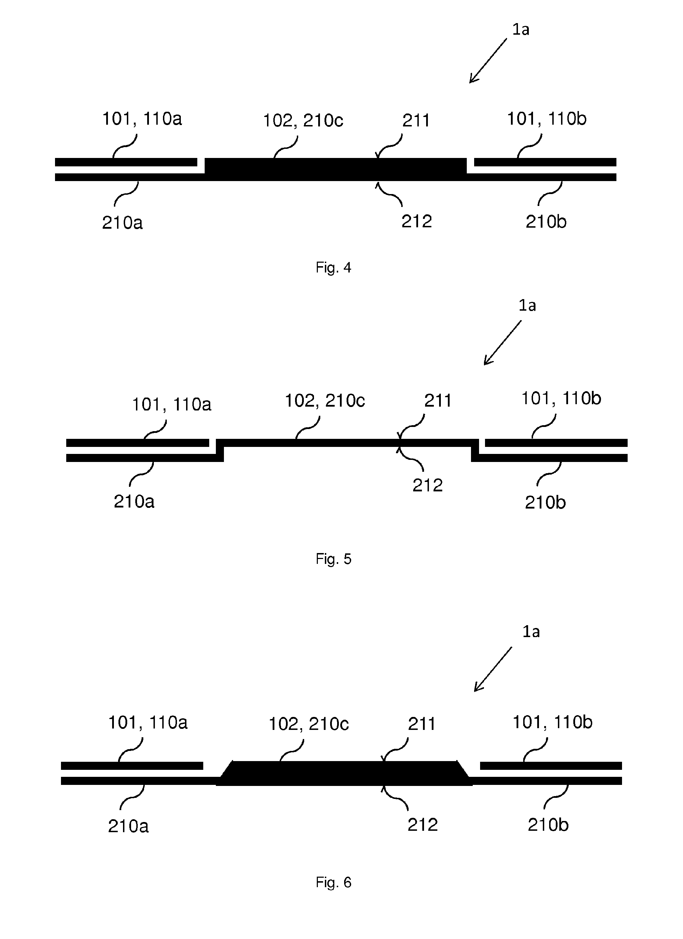

**Fig. 4** zeigt eine erste Ausgestaltung dieser Ausführungsform, wobei der zweite Gitterelektrodenbereich (210c) dicker als die ersten Gitterelektrodenbereiche (210a, 210b) der zweiten Gitterelektrode ist. Damit ist eine erste Oberfläche (211) des zweiten Gitterelektrodenbereichs (210c) in der ersten Lage (100) ausgebildet, während eine zweite Oberfläche (212) des zweiten Gitterelektrodenbereichs (210c) in der zweiten Lage (200) angeordnet ist. Die erste Oberfläche (211) und die zweite Oberfläche (212) liegen sich dabei gegenüber. Damit "ragt" die zweite Gitterelektrode in die erste Lage (100) "hinein". Der zweite Gitterelektrodenbereich (210c) ist vorzugsweise einstückig mit den ersten Gitterelektrodenbereichen (210a, 210b) der zweiten Gitterelektrode ausgebildet und kann bspw. mit Hilfe eines additiven (selektive Abscheidung) oder eines subtraktiven (Ätzverfahren) Verfahrens hergestellt werden. Vorzugsweise ist weiterhin die Geometrie der Öffnungen, bspw. der Lochdurchmesser, im zweiten Gitterelektrodenbereich (210c) gegenüber der der Öffnungen in den ersten Gitterelektrodenbereichen (210a, 210b) verändert, um die Auswirkungen der größeren Dicke dieses Bereiches auf die hindurchtretenden Ladungsträger auszugleichen. Alternativ oder zusätzlich können die Öffnungen im zweiten Gitterelektrodenbereich (210c) auch anders als in den ersten Gitterelektrodenbereichen (210a, 210b) angeordnet sein.

**Fig. 5** zeigt eine zweite Ausgestaltung der ersten Ausführungsform, bei der der zweite Gitterelektrodenbereich (210c) die selbe Dicke wie die ersten Gitterelektrodenbereiche (210a, 210b) der zweiten Gitterelektrode aufweist und einstückig mit diesen ausgebildet ist. Damit ist die zweite Gitterelektrode in die erste Lage (100) "hineingestülpt". Diese Ausgestaltung kann bspw. durch ein Umformverfahren der zweiten Gitterelektrode, wie z.B. Gesenkformen, hergestellt werden. Auch hier können sich die Geometrie und/oder die Anordnung der Öffnungen in dem zweiten Gitterelektrodenbereich (210c) von der in den ersten Gitterelektrodenbereichen (210a, 210b) unterscheiden.

In beiden Ausgestaltungen der ersten Ausführungsform können zur Vermeidung von Inhomogenitäten im elektrischen Feld und der mechanischen Beanspruchungen der zweiten Gitterelektrode die Übergänge zwischen den ersten Gitterelektrodenbereichen (210a, 210b) und dem zweiten Gitterelektrodenbereich (210c) stetig ausgebildet sein. Dies ist beispielhaft für die erste Ausgestaltung in **Fig. 6** dargestellt. Dabei verläuft der Übergang zwischen der ersten Oberfläche (211) des zweiten Gitterelektrodenbereichs (210c) zur Oberfläche der ersten Gitterelektrodenbereiche (210a, 210b) jeweils schräg. Alternativ oder zusätzlich können die Oberflächen der zweiten Gitterelektrode an den Übergangsstellen abgerundet sein, so dass ein runde "Kante" entsteht.

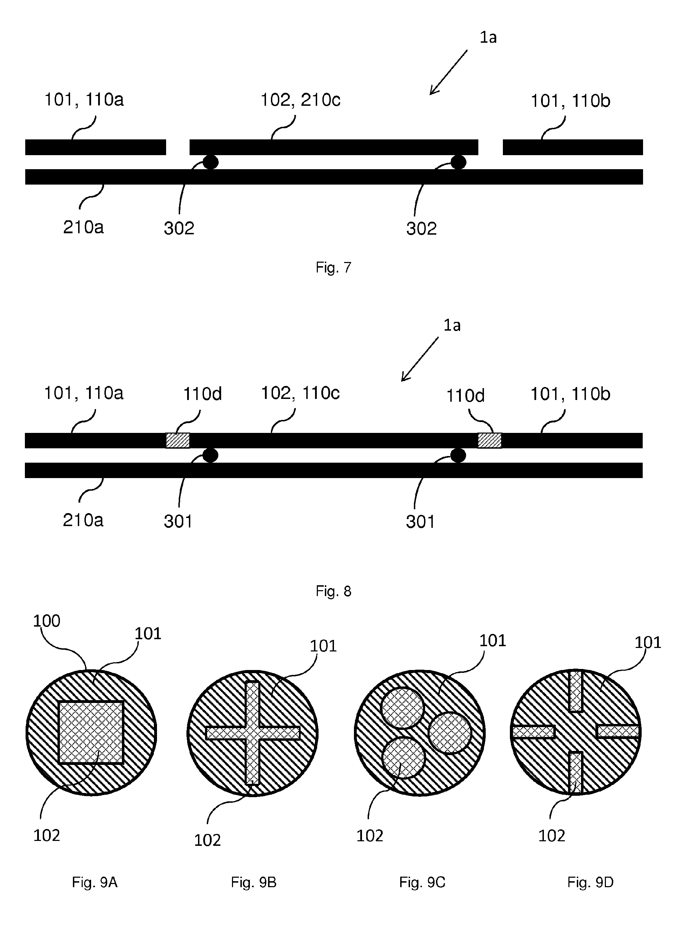

**Fig. 7** zeigt eine weitere Ausgestaltung der ersten Ausführungsform, bei der der zweite Gitterelektrodenbereich (210c) der zweiten Gitterelektrode nicht einstückig mit dem ersten Gitterelektrodenbereich (210a) der zweiten Gitterelektrode ausgebildet ist. Hierbei bildet der erste Gitterelektrodenbereich (210a) die zweite Lage (200) vollständig ab, während der zweite Gitterelektrodenbereich (210c) mit dem ersten Abstand (300) von dem ersten Gitterelektrodenbereich (210a) der zweiten Gitterelektrode beabstandet und über mindestens einen elektrisch leitenden Abstandshalter (302) mit dem ersten Gitterelektrodenbereich (210a) der zweiten Gitterelektrode verbunden ist. Solche Abstandshalter (302) können beispielsweise Bumps, Kugeln, Zylinder oder ähnliches sein, die sowohl die elektrische Verbindung als auch die mechanische Stabilität der Anordnung des zweiten Gitterelektrodenbereichs (210c) in der ersten Lage (100) gewährleisten. Der zweite Gitterelektrodenbereich (210c) der zweiten Gitterelektrode weist - außer über die Abstandshalter (302) - keine physische (mechanische) Verbindung zu den ersten Gitterelektrodenbereichen (110a, 110b) der ersten Gitterelektrode auf. Der zweite Gitterelektrodenbereich (210c) kann als eigenständiges Bauteil erzeugt werden, das anschließend mit dem ersten Gitterelektrodenbereich (210a) mittels der Abstandshalter (302) verbunden wird. Jedoch ist es auch möglich, den zweiten Gitterelektrodenbereich (210c) gemeinsam mit dem ersten Gitterelektrodenbereich (210a) der zweiten Gitterelektrode oder mit den ersten Gitterelektrodenbereichen (110a, 110b) der ersten Gitterelektrode herzustellen, und später eine physische bzw. mechanische "Trennung" zu erzeugen.

In einer zweiten Ausführungsform der erfindungsgemäßen Elektrodenanordnung (1a) weist die erste Gitterelektrode neben den ersten Gitterelektrodenbereichen (110a, 110b) einen zweiten Gitterelektrodenbereich (110c) auf, der physisch (mechanisch) mit den ersten Gitterelektrodenbereichen (110a, 110b) verbunden ist und den zweiten Lagenanteil (102) der ersten Lage (100) bildet. Damit bildet die erste Gitterelektrode die gesamte erste Lage (100) ab. Dies ist in **Fig. 8** dargestellt. Der zweite Gitterelektrodenbereich (110c) der ersten Gitterelektrode ist durch elektrisch isolierende Gitterelektrodenbereiche (110d) von den ersten Gitterelektrodenbereichen (110a, 110b) elektrisch isoliert und elektrisch leitend mit dem ersten Gitterelektrodenbereich (210a) der zweiten Gitterelektrode, die die zweite Lage (200) vollständig ausfüllt, über mindestens eine elektrisch leitende Verbindung (301) verbunden. Diese elektrisch leitenden Verbindungen (301) können wieder die bereits mit Bezug auf Fig. 7 beschriebenen Abstandshalter sein, die jedoch in dieser Ausführungsform nicht die mechanische Stabilität der Anordnung gewährleisten müssen, da diese bereits durch die elektrisch isolierenden Gitterelektrodenbereiche (110d) der ersten Gitterelektrode gegeben ist.

Wie bereits erwähnt, kann der zweite Lagenanteil (102) durch einen zusammenhängenden Gitterelektrodenbereich ausgebildet sein. Dies ist in den **Fig. 9A** und **9B** dargestellt, die die erste Lage (100) mit dem ersten Lagenanteil (101) und dem zweiten Lagenanteil (102) zeigt. Die elektrische Isolierung durch einen physischen Abstand oder einen elektrisch isolierenden Zwischenbereich zwischen den beiden Lagenanteilen ist hierbei nicht dargestellt.

Die **Fig. 9C** und **9D** zeigen andere Ausführungsbeispiele, bei denen der zweite Lagenanteil (102) durch mehrere, voneinander beabstandete Gitterelektrodenbereiche ausgebildet ist. In Fig. 9C bilden drei runde Gitterelektrodenbereiche den zweiten Lagenanteil (102), während in Fig. 9D vier rechteckige Gitterelektrodenbereiche den zweiten Lagenanteil (102) bilden. In den dargestellten Beispielen sind die Gitterelektrodenbereiche des zweiten Lagenanteils (102) jeweils alle gleichartig hinsichtlich ihrer Umfangsgeometrie ausgebildet und gleichförmig innerhalb der ersten Lage (100) angeordnet, bspw. in Bezug auf einen Mittelpunkt der ersten Lage (100). Jedoch ist dies nicht notwendig, so dass die einzelnen Gitterelektrodenbereiche auch verschieden hinsichtlich ihrer Umfangsgeometrie und/oder ihrer Anordnung innerhalb der ersten Lage (100) ausgestaltet sein können. In Fig. 9D ist ebenfalls zu sehen, dass die Gitterelektrodenbereiche, die den zweiten Lagenanteil (102) bilden, auch an den Umfang der ersten Lage (100) angrenzen können.

Die Umfangsgeometrie der ersten Lage (100) sowie der Gitterelektrodenbereiche, die den zweiten Lagenanteil (102) bilden, ist nicht auf die dargestellten Geometrien beschränkt. Ebenfalls ist eine andere Anordnung der Gitterelektrodenbereiche, die den zweiten Lagenanteil (102) bilden, innerhalb der ersten Lage (100) möglich. Die Umfangsgeometrien und Abmessungen der Gitterelektrodenbereiche, die den zweiten Lagenanteil (102) bilden, sowie deren Anordnung innerhalb der ersten Lage (100) stellen ein Muster der Elektrodenanordnung (1a) dar.

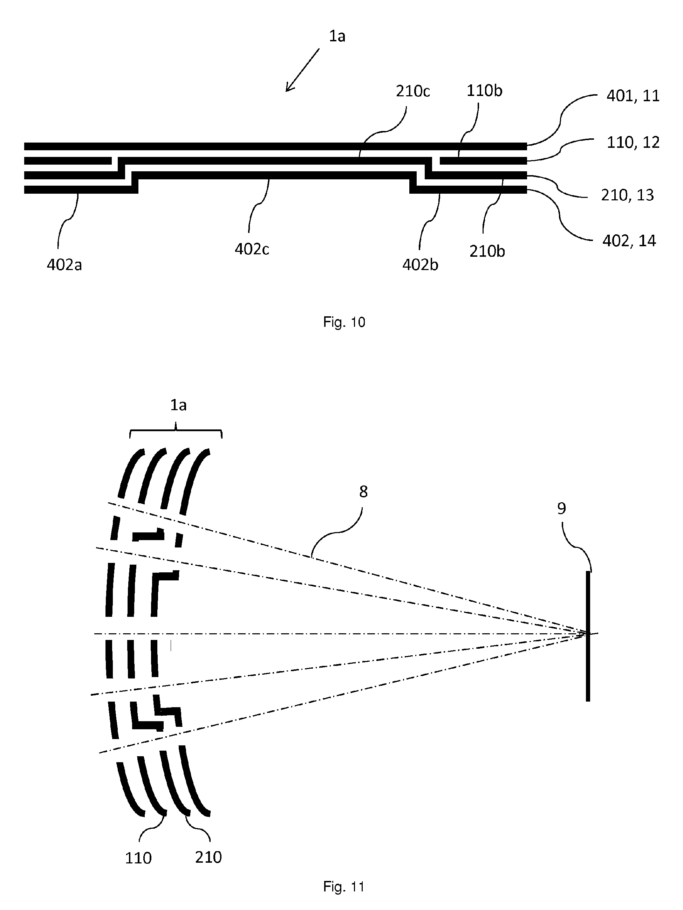

Neben der ersten Gitterelektrode und der zweiten Gitterelektrode kann die Elektrodenanordnung noch weitere Gitterelektroden aufweisen, die ebenfalls elektrisch leitfähig sind und korrespondierende Öffnungen aufweisen. In **Fig. 10** sind beispielhaft zwei weitere Gitterelektroden abgebildet, so dass die Elektrodenanordnung (1a) aus vier Gitterelektroden besteht. Diese sind im dargestellten Fall die erste Gitterelektrode (110), die eine Schaltgitterelektrode (12) realisiert, die zweite Gitterelektrode (210), die eine Beschleunigungsgitterelektrode (13) darstellt, sowie zwei weitere Gitterelektroden (401, 402), die als Plasmagitterelektrode (11) und Massegitterelektrode (14) fungieren. In anderen Ausführungsbeispielen können die Gitterelektroden auch anders angeordnet sein, wobei dann auch die Funktionalitäten der Gitterelektroden anders zugordnet sind. Beispielsweise ist es auch möglich, dass die erste Gitterelektrode (110) die Schaltgitterelektrode ist und die Plasmagitterelektrode die zweite Gitterelektrode (210) realisiert. Jedoch sind die Gitterelektroden in Teilchenaustrittsrichtung, d.h. von dem Ladungserzeugungsraum weg, immer in folgender Reihenfolge angeordnet: Plasmagitterelektrode (11), Schaltgitterelektrode (12), Beschleunigungsgitterelektrode (13) und Massegitterelektrode (14). Dabei können weitere Gitterelektroden bspw. zwischen der Plasmagitterelektrode (11) und der Schaltgitterelektrode (12) oder zwischen der Beschleunigungsgitterelektrode (13) und der Massegitterelektrode (14) angeordnet sein, jedoch nicht zwischen den Gitterelektroden, die die erste Gitterelektrode und die zweite Gitterelektrode bilden.

Die weiteren Gitterelektroden (401, 402) umfassen jeweils mindestens einen ersten Gitterelektrodenbereich, der in einer weiteren Lage angeordnet ist, wobei die weitere Lage und die zu ihr benachbarte Lage voneinander durch einen weiteren Abstand entlang der Teilchenaustrittsrichtung beabstandet sind. Wie in Fig. 10 dargestellt, ist die Plasmagitterelektrode (11) in einer dritten Lage angeordnet, die durch einen zweiten Abstand von der ersten Lage beabstandet ist, wobei die Plasmagitterelektrode (11) im dargestellten Fall nur Gitterelektrodenbereiche in der dritten Lage aufweist. Damit ist die Plasmagitterelektrode (11) gleichförmig ausgebildet und weist keine "Ausbuchtungen" oder andere Unregelmäßigkeiten auf, die bspw. ein Plasma ungünstig beeinflussen können.

Wenn die zweite Gitterelektrode (210), im dargestellten Fall also die Beschleunigungsgitterelektrode (13), gemäß der zweiten Ausgestaltung der ersten Ausführungsform der Elektrodenanordnung (1a), wie in Fig. 5 dargestellt, ausgestaltet ist und damit in die erste Lage "hineingestülpt" ist, kann eine (oder auch mehrere) der weiteren Gitterelektroden, die auf der von der ersten Gitterelektrode (110) abgewandten Seite der zweiten Gitterelektrode (210) angeordnet ist, zweite Gitterelektrodenbereiche aufweisen, die in der zweiten Lage angeordnet sind. Mit anderen Worten: Dann können auch weitere Gitterelektroden in die jeweils benachbarte Lage hineingestülpt sein. Dies ist in Fig. 10 beispielhaft für die Massegitterelektrode (14) gezeigt, die erste Gitterelektrodenbereiche (402a, 402b) und einen zweiten Gitterelektrodenbereich (402c) aufweist. Die ersten Gitterelektrodenbereiche (402a, 402b) sind in einer vierten Lage angeordnet, die mit einem dritten Abstand zur zweiten Lage beabstandet ist, während der zweite Gitterelektrodenbereich (402c) in der zweiten Lage angeordnet ist. Damit sind vorteilhafter Weise die Abstände zwischen Bereichen mit verschiedenem Potential, bspw. zwischen der Beschleunigungsgitterelektrode (13) und der Massegitterelektrode (14), über die gesamte Ausdehnung der betreffenden Gitterelektroden hinweg gleich, so dass ein gleichmäßiger Teilchenstrahl entsteht.

**Fig. 11** zeigt ein Beispiel für eine Elektrodenanordnung (1a), bei der die einzelnen Lagen nicht eben, sondern gekrümmte Flächen sind, so dass die einzelnen, durch die Öffnungen in den Gitterelektroden hindurchtretenden Teilchenteilstrahlen (8) fokussiert werden, so dass sie alle in einer gemeinsamen Auftrefffläche auf einem Substrat (9) konzentriert auftreffen. Die Elektrodenanordnung (1a) weist wieder die mit Bezug auf Fig. 10 beschriebenen Gitterelektroden auf, wobei die erste Gitterelektrode (110) und die zweite Gitterelektrode (210) wie in der mit Bezug auf die Fig. 5 beschriebenen Ausgestaltung ausgebildet sind. Eine Anpassung der Umfangsgeometrien, der Abmessungen und/oder der Anordnung der Öffnungen in den einzelnen Gitterelektroden ist vorteilhaft, um die Ausgestaltung der Lagen als gekrümmte Flächen, also als Flächen mit einem aufgeprägten, endlichen Radius, auszugleichen.

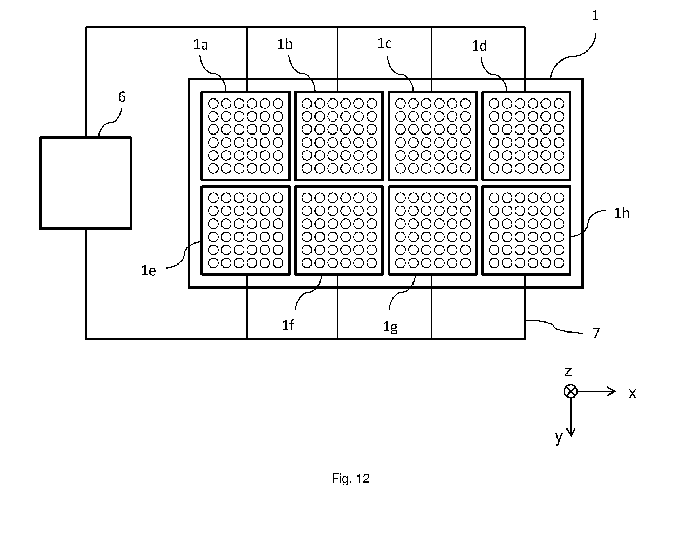

In **Fig. 12** ist eine Ausführungsform der erfindungsgemäßen Vorrichtung (1) zur Extraktion von Ladungsträgern mit einer Mehrzahl von Elektrodenanordnungen (1a - 1h) in der Draufsicht dargestellt. Dabei sind die Elektrodenanordnungen (1a - 1h) in einer 4x2-Matrix angeordnet, d.h. in zwei Zeilen sind jeweils vier Elektrodenanordnungen (1 a - 1 d bzw. 1 e - 1 h) angeordnet. Damit sind entlang einer ersten lateralen Ausdehnung der Vorrichtung (1), d.h. entlang der x-Richtung, vier Elektrodenanordnungen (1a - 1d bzw. 1e - 1h) nebeneinander angeordnet, während entlang einer zweiten lateralen Ausdehnung der Vorrichtung (1), d.h. entlang der y-Richtung, nur zwei Elektrodenanordnungen nebeneinander angeordnet sind. Somit sind alle Elektrodenanordnungen (1a - 1h) vom äußeren Umfang der Vorrichtung (1) aus elektrisch kontaktierbar, so dass sie über die Schaltvorrichtung (6) oder mehrere Schaltvorrichtungen und die entsprechenden elektrischen Leitungen (7) mit einem bzw. mehreren elektrischen Potentialen beaufschlagt werden können. Im dargestellten Fall weisen alle Elektrodenanordnungen (1a - 1 h) dasselbe Muster der Lagenanteile der ersten Lage auf, wobei jedoch auch eine oder mehrere oder alle Elektrodenanordnungen verschiedene Muster aufweisen können. Wie dargestellt, decken die Elektrodenanordnungen (1a - 1h) nahezu die gesamte laterale Ausdehnung der Vorrichtung (1) ab, wobei lediglich Randbereiche sowie Zwischenbereiche zwischen den einzelnen Elektrodenanordnungen (1a - 1h) nicht bedeckt sind.

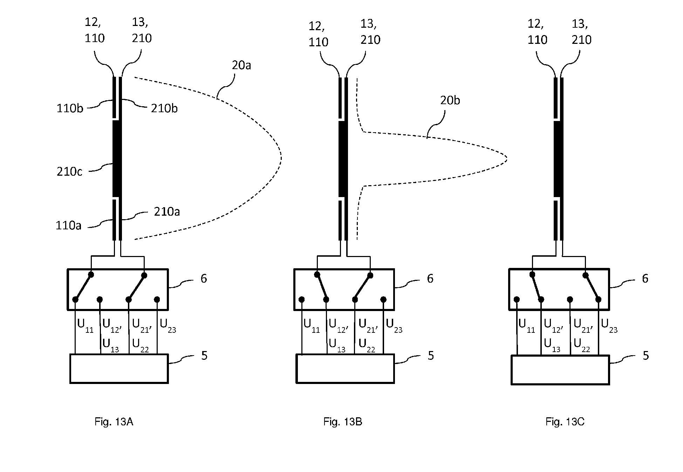

Mit Bezug auf die **Fig. 13A bis 13C** wird beispielhaft an einem Ausführungsbeispiel erläutert, wie die erfindungsgemäße Vorrichtung (1) betrieben wird, so dass eine gewünschte Strahlcharakteristik des durch mindestens eine Elektrodenanordnung (1a) hindurchtretenden Teilchenstrahls erzeugt wird. Im Ausführungsbeispiel ist die Beschaltung einer Elektrodenanordnung gezeigt, die eine Schaltgitterelektrode (12), die als erste Gitterelektrode (110) fungiert, und eine Beschleunigungsgitterelektrode (13), die als zweite Gitterelektrode (210) fungiert, aufweist, wobei die Beschleunigungsgitterelektrode (13) in Teilchenaustrittsrichtung nach der Schaltgitterelektrode (12) angeordnet ist. Die erste Gitterelektrode (110) und die zweite Gitterelektrode (210) sind bspw. wie in der in Fig. 4 dargestellten ersten Ausgestaltung der ersten Ausführungsform ausgebildet. Die erste Gitterelektrode (110) und die zweite Gitterelektrode (210) sind über eine Schaltvorrichtung (6) mit einer Vorrichtung (5) zur Erzeugung von elektrischen Spannungen verbunden, die mindestens zwei verschiedene Werte für ein erstes Potential der ersten Gitterelektrodenbereiche (110a, 110b) der ersten Gitterelektrode (110) und mindestens zwei verschiedene Werte für ein zweites Potential der ersten Gitterelektrodenbereiche (210a, 210b) der zweiten Gitterelektrode (210) und des mit diesen elektrisch leitend verbundenen zweiten Gitterelektrodenbereichs (210c) der zweiten Gitterelektrode (210) bereitstellen kann. Es können auch mehrere Schaltvorrichtungen (6) und/oder mehrere Vorrichtungen (5) zur Erzeugung von elektrischen Spannungen genutzt werden.

In einem ersten Schaltzustand, dargestellt in Fig. 13A, weisen das erste Potential einen ersten Wert U₁₁ und das zweite Potential einen zweiten Wert U₂₁ auf, wobei die Werte geeignet sind, Ladungsträger aus dem Ladungserzeugungsraum zu extrahieren. D.h. der erste Wert U₁₁ und der zweite Wert U₂₁ sind für positive Ladungsträger kleiner (negativer) als der Wert des Potentials im Ladungsträgererzeugungsraum oder des Potentials einer Plasmagitterelektrode (im Folgenden U_{beam} genannt), während es für negative Ladungsträger umgekehrt ist. Dabei kann der Betrag des zweiten Wertes U₂₁ bspw. um maximal ± 10% vom Betrag des ersten Wertes U₁₁ abweichen. Jedoch sind auch größere Unterschiede möglich, solange das erste und das zweite Potential den Durchtritt von Ladungsträgern durch alle Gitterelektrodenbereiche erlauben. Da die Potentiale der ersten Gitterelektrodenbereiche (110a, 110b) der ersten Gitterelektrode (110) sowie der ersten Gitterelektrodenbereiche (210a, 210b) und des zweiten Gitterelektrodenbereichs (210c) der zweiten Gitterelektrode (210) beide geeignet sind, Ladungsträger zu extrahieren, so wird die gesamte laterale Ausdehnung der Elektrodenanordnung zur Extraktion von Ladungsträgern genutzt. Damit entsteht ein Gesamtstrahl (20a), der eine große laterale Ausdehnung aufweist. Bspw. kann ein derartiger, fokussierter Ionenstrahl für eine beispielhafte Elektrodenanordnung mit einem Gitterelektrodendurchmesser von 40 mm einen Auftreffdurchmesser auf einer zu bearbeitenden Substratoberfläche von ca. 4,5 mm aufweisen. Unter "Gitterelektrodendurchmesser" wird hierbei der Durchmesser eines kreisrunden Bereiches der Elektrodenanordnung bezogen auf eine Lage verstanden, in dem Gitterelektrodenbereiche ausgebildet sind. Die Gitterelektrodenbereiche weisen die oben beschriebenen Öffnungen auf, während die einzelnen Gitterelektroden daneben auch Randbereiche, bspw. zum physischen Befestigen der Gitterelektrode in einem Gehäuse oder einer anderen Vorrichtung oder zum Anlegen eines Potentials an die Gitterelektrode, aufweisen können, in denen keine Öffnungen ausgebildet sind. Damit können sowohl die lateralen Abmessungen der Elektrodenanordnung als auch die Umfangsgeometrie der Elektrodenanordnung von diesem Bereich verschieden sein.

In einem zweiten Schaltzustand, dargestellt in Fig. 13B, weist das erste Potential einen dritten Wert U₁₂ auf, während das zweite Potential einen vierten Wert U22 aufweist. Dabei ist der dritte Wert U₁₂ geeignet, die Extraktion von Ladungsträgern aus dem Ladungsträgererzeugungsraum zu verhindern oder sehr stark einzuschränken. Mit anderen Worten: Für positive Ladungsträger ist der dritte Wert U₁₂ größer (positiver) als der Wert des Potentials im Ladungsträgererzeugungsraum oder als U_{beam}, während es für negative Ladungsträger umgekehrt ist. Der vierte Wert U₂₂ ist hingegen zur Extraktion von Ladungsträgern geeignet, wobei der vierte Wert U₂₂ gleich dem zweiten Wert U₂₁ sein kann, wie dies in Fig. 13B dargestellt ist. Jedoch kann der vierte Wert U₂₂ auch verschieden von dem zweiten Wert U₂₁ sein, um die veränderten elektrischen Umgebungsbedingungen auszugleichen. Damit trägt nur noch der zweite Gitterelektrodenbereich (210c) der zweiten Gitterelektrode (210), der den zweiten Lagenanteil der ersten Lage bildet und mit den ersten Gitterelektrodenbereichen (210a, 210b) der zweiten Gitterelektrode (210) elektrisch leitend verbunden ist, zur Extraktion von Ladungsträgern bei, während die ersten Gitterelektrodenbereiche (210a, 201 b) der zweiten Gitterelektrode (210) durch die ersten Gitterelektrodenbereiche (110a, 110b) der ersten Gitterelektrode (110) abgeschirmt sind. Daher bildet der Teilstrahl (20b) nur die Geometrie der zweiten Lagenanteile der ersten Lage ab und hat Abmessungen, die kleiner als die des Gesamtstrahls (20a) sind. Im dargestellten Beispiel wird somit ein Teilstrahl (20b) mit einem geringeren Durchmesser von bspw. ca. 2 mm erzeugt, wobei der Durchmesser des zweiten Gitterbereiches (210c) der zweiten Gitterelektrode (210), d.h, der Durchmesser des zweiten Lagenanteils der ersten Lage, 10 mm beträgt.

In einem dritten Schaltzustand, dargestellt in Fig. 13C, weisen das erste Potential einen fünften Wert U₁₃ und das zweite Potential einen sechsten Wert U₂₃ auf, wobei der fünfte Wert U₁₃ und der sechste Wert U₂₃ geeignet sind, die Extraktion von Ladungsträgern aus dem Ladungsträgererzeugungsraum zu verhindern oder sehr stark einzuschränken. Der fünfte Wert U₁₃ und der sechste Wert U₂₃ sind damit für positive Ladungsträger größer (positiver) als der Wert des Potentials im Ladungsträgererzeugungsraum oder als U_{beam}, während es für negative Ladungsträger umgekehrt ist. Der fünfte Wert U₁₃ kann gleich dem dritten Wert U₁₂ sein, wie dies in Fig. 13C dargestellt ist. Jedoch kann der fünfte Wert U₁₃ auch verschieden von dem dritten Wert U₁₂ sein, um die veränderten elektrischen Umgebungsbedingungen auszugleichen. Darüber hinaus kann der sechste Wert U₂₃ gleich oder nahezu gleich oder verschieden von dem fünften Wert U₁₃ sein. Da nunmehr alle Lagenanteile der ersten Lage auf einem Potential liegen, das die Extraktion von Ladungsträgern verhindert, wird kein Teilchenstrahl erzeugt.

In der folgenden Tabelle sind Beispielwerte für das Potential eines Plasmagitters sowie für durchlassende oder sperrende Werte des ersten und zweiten Potentials für positive Ladungsträger aufgeführt:

| U_{beam} | U₁₁ | U₁₂, U₁₃ | U₂₁, U₂₂ | U₂₃ |
|---|---|---|---|---|
| 700 V | -100 V | 800 ... 900 V | -100 V | 800 ... 900 V |

Darüber hinaus können auch noch weitere Schaltzustände mit weiteren Werten des ersten oder des zweiten Potentials bereitgestellt werden. Damit können auch Teilchenstrahlen erzeugt werden, die andere Formen als die hier dargestellten aufweisen, bspw. ein Teilchenstrahl, der sich zwar über die gesamte laterale Ausdehnung der Elektrodenanordnung erstreckt, jedoch im Bereich des ersten Lagenanteils eine andere Teilchendichte oder Teilchenenergie aufweist als im Bereich des zweiten Lagenanteils.

Das erste und/oder das zweite Potential können auch gepulst beaufschlagt werden, wobei die Pulsdauer sowie das Pulsverhältnis gleich oder verschieden voneinander und/oder über die Zeit sein können.

Das Plasmagitter kann wie oben dargestellt mit einem dritten Potential U_{beam} beaufschlagt werden oder floaten.

Wenn die Elektrodenanordnung nach dem Beschleunigungsgitter weiterhin eine Massegitterelektrode aufweist, dann ist diese vorzugsweise geerdet.

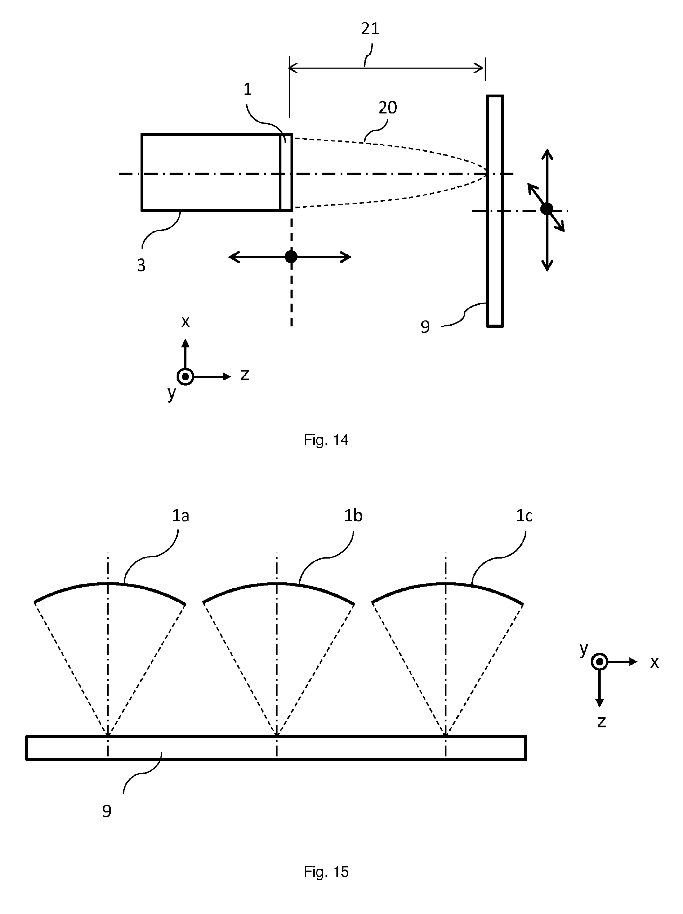

Mit Bezug auf die Fig. 14 bis 16 wird nachfolgend ein Verfahren zur Bearbeitung einer Oberfläche eines Substrates (9) unter Nutzung eines oder mehrerer Teilchenstrahlen aus mindestens einer erfindungsgemäßen Vorrichtung (1) erläutert.

In **Fig. 14** ist eine Teilchenstrahlquelle (3) dargestellt, die die erfindungsgemäße Vorrichtung (1) zur Extraktion von elektrischen Ladungsträgern umfasst und einen Teilchenstrahl (20) erzeugt, der auf die Oberfläche eines Substrates (9) auftrifft und diese bearbeitet. Dabei sind die Teilchenstrahlquelle (3) und die Substratoberfläche mit einem Abstand (21) entlang der z-Richtung, d.h. der Teilchenaustrittsrichtung, angeordnet, der durch eine Bewegung der Teilchenstrahlquelle (3) und/oder des Substrates (9) entlang der z-Richtung veränderbar ist. Darüber hinaus können die Teilchenstrahlquelle (3) und/oder das Substrat (9) lateral, d.h. in x-und/oder y-Richtung, bewegt, zur z-Richtung und/oder zur x-y-Ebene gekippt und/oder um eine Achse, die parallel zur z-Richtung verläuft, rotiert werden. Alle Bewegungen können gleichförmig oder ungleichförmig ausgeführt werden. Während der Bearbeitung der Substratoberfläche wird die Strahlcharakteristik des Teilchenstrahls (20) in Abhängigkeit von einem bekannten Eigenschaftsmuster der Substratoberfläche und vom Verfahrensfortschritt so mit Hilfe des oben beschriebenen Verfahrens zur Steuerung der Strahlcharakteristik (Fig. 13A bis 13C) gesteuert, dass nach Beendigung der Bearbeitung ein gewünschtes Eigenschaftsmuster der Substratoberfläche vorliegt. Bspw. kann die Substratoberfläche in großflächigen Bereichen mit einem homogenen Eigenschaftsmuster mit einem Teilchenstrahl mit großer lateraler Ausdehnung, bspw. dem Gesamtstrahl (20a) aus Fig. 13A, bearbeitet werden, während zur Bearbeitung kleinerer Bereiche mit einem homogenen Eigenschaftsmuster ein Teilchenstrahl mit einer kleineren lateralen Ausdehnung, bspw. der Teilstrahl (20b) aus Fig. 13B, eingesetzt wird. Auch die gewünschte Bearbeitungsqualität oderquantität in einem bestimmten Bereich der Substratoberfläche kann für die Auswahl einer bestimmten Strahlcharakteristik entscheidend sein.

Werden mehrere Teilchenstrahlen aus einer oder mehreren erfindungsgemäßen Vorrichtungen (1) zur Extraktion von elektrischen Ladungsträgern zur Bearbeitung der Substratoberfläche eingesetzt, so kann die Substratoberfläche gleichzeitig in mehreren lateralen Bereichen der Substratoberfläche bearbeitet werden. Dies ist schematisch in **Fig. 15** dargestellt, wobei beispielhaft drei Elektrodenanordnungen (1a - 1c) einer Vorrichtung (1) zur Extraktion von elektrischen Ladungsträgern gezeigt sind. Jedoch können die Elektrodenanordnungen (1a - 1c) auch jeweils in einer von mehreren Vorrichtungen (1) zur Extraktion von elektrischen Ladungsträgern enthalten sein, wobei eine spezifische Vorrichtung (1) zur Extraktion von elektrischen Ladungsträgern jeweils in einer spezifischen Teilchenstrahlquelle enthalten ist. Damit können bspw. gleiche oder unterschiedliche Verfahren, die unterschiedliche Teilchen oder unterschiedliche Strahlcharakteristiken zur Bearbeitung nutzen, gleichzeitig ausgeführt werden.

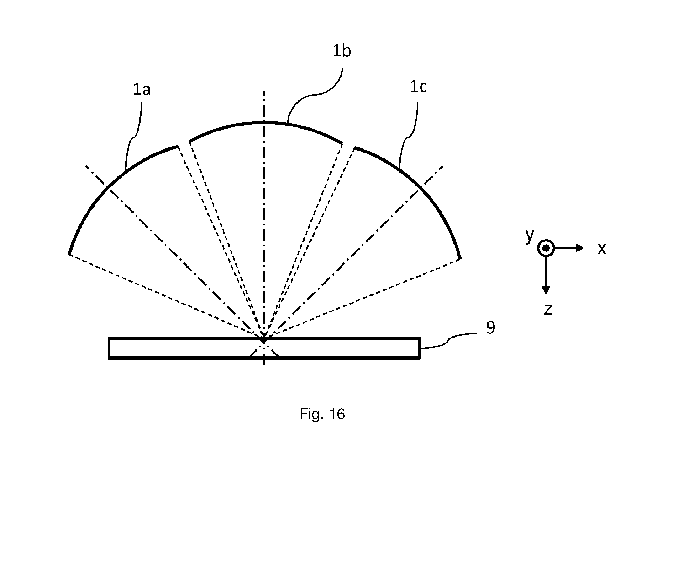

In **Fig. 16** ist eine weitere Ausführungsform des Verfahrens zum Bearbeiten einer Substratoberfläche dargestellt, bei der die mit Hilfe der Elektrodenanordnungen (1a - 1c) erzeugten Teilchenstrahlen aus einer oder mehreren Vorrichtungen (1) zur Extraktion von elektrischen Ladungsträgern auf einer gemeinsamen Fläche auf der Substratoberfläche auftreffen. Das heißt, die Teilchenstrahlen sind auf ein und denselben Oberflächenbereich ausgerichtet, wobei die gemeinsame Fläche von der Auftrefffläche desjenigen Teilchenstrahls mit der größten lateralen Ausdehnung in der Ebene der Substratoberfläche bestimmt wird. Die unterschiedlichen Teilchenstrahlen haben verschiedene laterale Abmessungen und können verschiedene Formen, Foki, Teilchendichten, Teilchenenergien und/oder Teilchenarten aufweisen. Damit können bspw. mit einem gemeinsamen Ätzschritt Strukturen in der Substratoberfläche geschaffen werden, die unterschiedliche Ätztiefen aufweisen, in dem bspw. ein Teilchenstrahl mit kleiner lateraler Ausdehnung und ein Teilchenstrahl mit großer lateraler Ausdehnung kombiniert werden. Dort, wo beide Teilchenstrahlen auftreffen, wird eine hohe Abtragsrate und damit eine große Ätztiefe erreicht, während in Bereichen, in denen nur der Teilchenstrahl mit der großen lateralen Ausdehnung auftrifft, nur eine geringe Abtragsrate und damit eine geringe Ätztiefe erreicht wird.

Alle Ausgestaltungen und Ausführungsformen der erfindungsgemäßen Vorrichtung (1) zur Extraktion von elektrischen Ladungsträgern sowie der Verfahren zum Betreiben der erfindungsgemäßen Vorrichtung (1) zur Extraktion von elektrischen Ladungsträgern und zum Bearbeiten einer Substratoberfläche können miteinander und untereinander kombiniert werden, so lange dies nicht explizit ausgeschlossen oder aus physikalischen und/oder technischen Gründen unmöglich ist.

### Bezugszeichenliste

- 1: Vorrichtung zur Extraktion von elektrischen Ladungsträgern
- 1a - 1h: Elektrodenanordnung gemäß der Erfindung
- 1a': Elektrodenanordnung nach dem Stand der Technik
- 2: Ladungsträgererzeugungsraum
- 3: Teilchenstrahlquelle
- 31: Gehäuse der Teilchenstrahlquelle
- 4: Elektrode(n)
- 5: Vorrichtung zur Erzeugung einer oder mehrerer elektrischer Spannungen
- 6: Schaltvorrichtung
- 7: Elektrische Leitung
- 8: Teilchenteilstrahl
- 9: Substrat
- 10: Laterale Ausdehnung der Elektrodenanordnung in x-Richtung
- 11: Plasmagitterelektrode gemäß der Erfindung
- 11': Plasmagitterelektrode nach dem Stand der Technik
- 12: Schaltgitterelektrode gemäß der Erfindung
- 12': Schaltgitterelektrode nach dem Stand der Technik
- 13: Beschleunigungsgitterelektrode gemäß der Erfindung
- 13': Beschleunigungsgitterelektrode nach dem Stand der Technik
- 14: Massegitterelektrode gemäß der Erfindung
- 14': Massegitterelektrode nach dem Stand der Technik
- 15: Gitterelektrodenmaterial
- 16: Öffnung in einer Gitterelektrode
- 17: Dicke einer Gitterelektrode
- 18: Abstand zwischen zwei Gitterelektroden
- 19: Laterale Ausdehnung der Elektrodenanordnung in y-Richtung
- 20: Teilchenstrahl
- 20a: Gesamtstrahl
- 20b: Teilstrahl
- 21: Abstand Vorrichtung zur Extraktion von elektrischen Ladungsträgern zur Substratoberfläche
- 100: Erste Lage
- 101: Erster Lagenanteil der ersten Lage
- 102: Zweiter Lagenanteil der ersten Lage
- 110: Erste Gitterelektrode
- 110a, 110b: Erster Gitterelektrodenbereich der ersten Gitterelektrode
- 110c: Zweiter Gitterelektrodenbereich der ersten Gitterelektrode
- 110d: Elektrisch isolierender Gitterelektrodenbereich der ersten Gitterelektrode
- 200: Zweite Lage
- 210: Zweite Gitterelektrode
- 210a, 210b: Erster Gitterelektrodenbereich der zweiten Gitterelektrode
- 210c: Zweiter Gitterelektrodenbereich der zweiten Gitterelektrode
- 211: Erste Oberfläche des zweiten Gitterelektrodenbereiches der zweiten Gitterelektrode
- 212: Zweite Oberfläche des zweiten Gitterelektrodenbereiches der zweiten Gitterelektrode
- 300: Erster Abstand (Abstand zwischen erster und zweiter Lage)
- 301: Elektrisch leitende Verbindung zwischen dem zweiten Lagenanteil der ersten Lage und den ersten Gitterelektrodenbereichen der zweiten Gitterelektrode
- 302: Elektrisch leitender Abstandshalter
- 401, 402: Weitere Gitterelektrode
- 401a, 402a: Erster Gitterelektrodenbereich der weiteren Gitterelektrode
- 402c: Zweiter Gitterelektrodenbereich der weiteren Gitterelektrode

## Patentansprüche

1. Vorrichtung zur Extraktion von elektrischen Ladungsträgern aus einem Ladungsträgererzeugungsraum mit mindestens einer Elektrodenanordnung zur Extraktion von Ladungsträgern, wobei die mindestens eine Elektrodenanordnung mindestens eine erste Gitterelektrode und eine zweite Gitterelektrode mit korrespondierenden Öffnungen aufweist, die jeweils mindestens einen ersten elektrisch leitfähigen Gitterelektrodenbereich enthalten, wobei der mindestens eine erste Gitterelektrodenbereich der ersten Gitterelektrode in einer ersten Lage und der mindestens eine erste Gitterelektrodenbereich der zweiten Gitterelektrode in einer zweiten Lage ausgebildet sind, wobei die erste Lage und die zweite Lage innerhalb der Elektrodenanordnung in Teilchenaustrittsrichtung nacheinander angeordnet und voneinander durch einen ersten Abstand entlang der Teilchenaustrittsrichtung beabstandet sind, wobei der mindestens eine erste Gitterelektrodenbereich der ersten Gitterelektrode in der ersten Lage einen ersten elektrisch leitfähigen Lagenanteil bildet und in der ersten Lage ein zweiter elektrisch leitfähiger Lagenanteil ausgebildet ist, wobei der erste Lagenanteil und der zweite Lagenanteil voneinander elektrisch isoliert sind, **dadurch gekennzeichnet, dass** der zweite Lagenanteil durch mindestens einen zweiten elektrisch leitfähigen Gitterelektrodenbereich der ersten Gitterelektrode oder der zweiten Gitterelektrode gebildet wird und der zweite Lagenanteil elektrisch leitend mit dem mindestens einen ersten Gitterelektrodenbereich der zweiten Gitterelektrode verbunden ist.

2. Vorrichtung nach Anspruch 1, **dadurch gekennzeichnet, dass** der mindestens eine erste Gitterelektrodenbereich der ersten Gitterelektrode und der mindestens eine erste Gitterelektrodenbereich der zweiten Gitterelektrode so innerhalb der jeweiligen Gitterelektrode angeordnet sind, dass sie jeweils an den äußeren lateralen Umfang der jeweiligen Gitterelektrode angrenzen.

3. Vorrichtung nach Anspruch 1 oder 2, **dadurch gekennzeichnet, dass** die erste Gitterelektrode nur den mindestens einen ersten Gitterelektrodenbereich umfasst und die zweite Gitterelektrode mindestens einen zweiten Gitterelektrodenbereich umfasst, der den zweiten Lagenanteil der ersten Lage bildet.

4. Vorrichtung nach Anspruch 3, **dadurch gekennzeichnet, dass** der mindestens eine zweite Gitterelektrodenbereich der zweiten Gitterelektrode so dick ausgebildet ist, dass eine erste Oberfläche des mindestens einen zweiten Gitterelektrodenbereichs sich in der ersten Lage befindet und eine zweite Oberfläche des mindestens einen zweiten Gitterelektrodenbereichs, die der ersten Oberfläche gegenüberliegt, sich in der zweiten Lage befindet.

5. Vorrichtung nach Anspruch 3, **dadurch gekennzeichnet, dass** der mindestens eine zweite Gitterelektrodenbereich der zweiten Gitterelektrode dieselbe Dicke aufweist wie der mindestens eine erste Gitterelektrodenbereich der zweiten Gitterelektrode.

6. Vorrichtung nach einem der Ansprüche 3 bis 5, **dadurch gekennzeichnet, dass** die Übergänge zwischen dem mindestens einen ersten Gitterelektrodenbereich der zweiten Gitterelektrode und dem mindestens einen zweiten Gitterelektrodenbereich der zweiten Gitterelektrode an beiden Oberflächen der zweiten Gitterelektrode stetig verlaufen.

7. Vorrichtung nach Anspruch 3, **dadurch gekennzeichnet, dass** der mindestens eine erste Gitterelektrodenbereich der zweiten Gitterelektrode die zweite Lage vollständig abbildet und der mindestens eine zweite Gitterelektrodenbereich der zweiten Gitterelektrode zumindest in einigen lateralen Abschnitten des zweiten Gitterelektrodenbereichs von dem mindestens einen ersten Gitterelektrodenbereich der zweiten Gitterelektrode beabstandet ist.

8. Vorrichtung nach Anspruch 1 oder 2, **dadurch gekennzeichnet, dass** die erste Gitterelektrode weiterhin mindestens einen zweiten Gitterelektrodenbereich umfasst, der den zweiten Lagenanteil der ersten Lage bildet.

9. Vorrichtung nach einem der vorhergehenden Ansprüche, **dadurch gekennzeichnet, dass** die Öffnungen für den Ladungsträgerdurchtritt in mindestens einem zweiten Gitterelektrodenbereich der ersten Gitterelektrode oder der zweiten Gitterelektrode gleich zu oder verschieden von den Öffnungen für den Ladungsträgerdurchtritt in mindestens einem ersten Gitterelektrodenbereich der zweiten Gitterelektrode bezüglich ihrer lateralen Ausdehnung und/oder ihrer Umfangsgeometrie sind.

10. Vorrichtung nach einem der vorhergehenden Ansprüche, **dadurch gekennzeichnet, dass** der zweite Lagenanteil durch einen zusammenhängenden zweiten Gitterelektrodenbereich der ersten Gitterelektrode oder der zweiten Gitterelektrode gebildet wird.

11. Vorrichtung nach einem der Ansprüche 1 bis 9, **dadurch gekennzeichnet, dass** der zweite Lagenanteil durch mehrere voneinander beabstandete zweite Gitterelektrodenbereiche der ersten Gitterelektrode oder der zweiten Gitterelektrode gebildet wird, wobei die mehreren voneinander beabstandeten zweiten Gitterelektrodenbereiche gleiche oder unterschiedliche Umfangsgeometrien aufweisen und gleichförmig oder ungleichförmig über die laterale Ausdehnung der ersten Lage verteilt sind.

12. Vorrichtung nach einem der vorhergehenden Ansprüche, **dadurch gekennzeichnet, dass** die mindestens eine Elektrodenanordnung mindestens eine weitere, elektrisch leitfähige und mit korrespondierenden Öffnungen versehene Gitterelektrode aufweist, die mindestens einen ersten Gitterelektrodenbereich in einer weiteren Lage umfasst, wobei die weitere Lage und die zu ihr benachbarte Lage voneinander durch einen weiteren Abstand entlang der Teilchenaustrittsrichtung beabstandet sind.

13. Vorrichtung nach den Ansprüchen 5 und 12, **dadurch gekennzeichnet, dass** eine weitere Gitterelektrode benachbart zur zweiten Gitterelektrode auf der von der ersten Gitterelektrode abgewandten Seite der zweiten Gitterelektrode angeordnet ist, und diese weitere Gitterelektrode weiterhin mindestens einen zweiten Gitterelektrodenbereich aufweist, der in der zweiten Lage angeordnet und elektrisch leitend mit dem mindestens einen ersten Gitterelektrodenbereich dieser weiteren Gitterelektrode verbunden ist, wobei die laterale Anordnung des mindestens einen zweiten Gitterelektrodenbereichs dieser weiteren Gitterelektrode innerhalb der zweiten Lage zu der lateralen Anordnung des mindestens einen zweiten Gitterelektrodenbereichs der zweiten Gitterelektrode innerhalb der ersten Lage korrespondiert.

14. Vorrichtung nach einem der vorhergehenden Ansprüche, **dadurch gekennzeichnet, dass** eine, mehrere oder alle der in der Elektrodenanordnung enthaltenen Gitterelektroden einzeln aus einer Halterung der Elektrodenanordnung oder von einer der anderen Gitterelektroden lösbar angeordnet ist.

15. Vorrichtung nach einem der vorhergehenden Ansprüche, **dadurch gekennzeichnet, dass** die Vorrichtung mehrere Elektrodenanordnungen zur Extraktion von elektrischen Ladungsträgern aufweist, wobei mehrere der Elektrodenanordnungen nebeneinander in einer ersten Richtung entlang der lateralen Ausdehnung der Vorrichtung und höchstens zwei Elektrodenanordnungen nebeneinander in einer zweiten Richtung entlang der lateralen Ausdehnung der Vorrichtung angeordnet sind, so dass die mehreren Elektrodenanordnungen nahezu die gesamte laterale Ausdehnung der Vorrichtung abdecken, und wobei die mehreren Elektrodenanordnungen gleiche oder unterschiedliche Muster der zweiten Lagenanteile aufweisen.

16. Vorrichtung nach einem der vorhergehenden Ansprüche, **dadurch gekennzeichnet, dass** die mindestens eine Elektrodenanordnung in Teilchenaustrittsrichtung nacheinander eine Plasmagitterelektrode, eine Schaltgitterelektrode und eine Beschleunigungsgitterelektrode umfasst, wobei die Schaltgitterelektrode die erste Gitterelektrode und die Plasmagitterelektrode oder die Beschleunigungsgitterelektrode die zweite Gitterelektrode ist.

17. Verfahren zum Betreiben einer Vorrichtung nach Anspruch 16, **dadurch gekennzeichnet, dass** in Abhängigkeit von einer gewünschten Strahlcharakteristik des durch eine der mindestens einen Elektrodenanordnung hindurchtretenden Teilchenstrahls jede der mindestens einen Elektrodenanordnung derart mit Hilfe einer Vorrichtung zur Erzeugung einer oder mehrerer elektrischer Spannungen sowie einer Schaltvorrichtung angesteuert wird, dass der mindestens eine erste Gitterelektrodenbereich der Schaltgitterelektrode der spezifischen Elektrodenanordnung mit einem ersten Potential und die Beschleunigungsgitterelektrode der spezifischen Elektrodenanordnung mit einem zweiten Potential beaufschlagt werden, wobei:
- in einem ersten Schaltzustand das erste Potential einen ersten Wert U₁₁ und das zweite Potential einen zweiten Wert U₂₁ aufweisen, die beide geeignet sind, den Durchtritt von Ladungsträgern durch die entsprechenden Gitterelektrodenbereiche zu ermöglichen,
- in einem zweiten Schaltzustand das erste Potential einen dritten Wert U₁₂ und das zweite Potential einen vierten Wert U₂₂ aufweisen, wobei der dritte Wert U₁₂ geeignet ist, den Durchtritt von Ladungsträgern durch die zu dem ersten Lagenanteil korrespondierenden Gitterelektrodenbereiche der Schaltgitterelektrode und der Beschleunigungsgitterelektrode zu verhindern, während der vierte Wert U₂₂ geeignet ist, den Durchtritt von Ladungsträgern durch die zu dem zweiten Lagenanteil korrespondierenden Gitterelektrodenbereiche der Schaltgitterelektrode und der Beschleunigungsgitterelektrode zu ermöglichen, und
- in einem dritten Schaltzustand das erste Potential einen fünften Wert U₁₃ und das zweite Potential einen sechsten Wert U₂₃ aufweisen, die beide geeignet sind, den Durchtritt von Ladungsträgern durch die entsprechenden Gitterelektrodenbereiche zu verhindern.

18. Verfahren nach Anspruch 17, **dadurch gekennzeichnet, dass** das erste Potential und/oder das zweite Potential gepulst beaufschlagt werden.

19. Verfahren nach Anspruch 17 oder 18, **dadurch gekennzeichnet, dass** die Plasmagitterelektrode mit einem dritten Potential U_{beam} beaufschlagt wird.

20. Verfahren nach einem der Ansprüche 17 bis 19, **dadurch gekennzeichnet, dass** die Elektrodenanordnung in Teilchenaustrittsrichtung nach der Beschleunigungsgitterelektrode eine elektrisch leitfähige und mit korrespondierenden Öffnungen versehene Massegitterelektrode aufweist, die mindestens einen ersten Gitterelektrodenbereich in einer dritten Lage umfasst, wobei die zweite Lage und die dritte Lage voneinander durch einen zweiten Abstand entlang der Teilchenaustrittsrichtung beabstandet sind, und die Massegitterelektrode geerdet wird.

21. Verfahren zur Bearbeitung der Oberfläche eines Substrates unter Nutzung eines oder mehrerer Teilchenstrahlen aus mindestens einer Vorrichtung nach einem der Ansprüche 1 bis 16, **dadurch gekennzeichnet, dass** während der Bearbeitung des Substrates in Abhängigkeit von einem bekannten Eigenschaftsmuster der Substratoberfläche und vom Verfahrensfortschritt die Strahlcharakteristik des einen oder von mehreren Teilchenstrahlen aus der mindestens einen Vorrichtung zur Extraktion von elektrischen Ladungsträgern aus einem Ladungsträgererzeugungsraum mit Hilfe des Verfahrens nach einem der Ansprüche 17 bis 20 in definierter Weise verändert wird.

22. Verfahren nach Anspruch 21, **dadurch gekennzeichnet, dass** gleichzeitig mehrere Teilchenstrahlen aus mindestens einer Vorrichtung zur Extraktion von elektrischen Ladungsträgern aus einem Ladungsträgererzeugungsraum auf das Substrat auftreffen, wobei die mehreren Teilchenstrahlen gleiche oder verschiedene Strahlcharakteristiken aufweisen.

23. Verfahren nach Anspruch 22, **dadurch gekennzeichnet, dass** mehrere Teilchenstrahlen auf eine gemeinsame Fläche auf der Substratoberfläche auftreffen, wobei die mehreren Teilchenstrahlen unterschiedliche Strahlcharakteristiken aufweisen und wobei die gemeinsame Fläche in etwa der Auftrefffläche desjenigen auftreffenden Teilchenstrahls, der die größte Auftrefffläche aller auftreffenden Teilchenstrahlen aufweist, entspricht.
